# EUROPEAN PATENT APPLICATION

(11) **EP 4 144 743 A1**
(43) Date of publication of application: **08.03.2023**
(21) Application number: 21792323.4
(22) Date of filing: 31.03.2021
(51) Int. Cl.: C07F 15/00, C09K 11/06, C07B 61/00, H01L 51/50

(54) **METAL COMPLEX, COMPOSITION AND LIGHT EMITTING ELEMENT**

(30) Priority: 21.04.2020 JP 2020075631
(71) Applicant: SUMITOMO CHEMICAL COMPANY, LIMITED, Tokyo 103-6020 (JP)
(72) Inventor: USUI, Motoaki, Osaka 554-8558 (JP); MATSUMOTO, Ryuji, Tsukuba-shi, Ibaraki 300-3294 (JP); FUKUSHIMA, Daisuke, Tsukuba-shi, Ibaraki 300-3294 (JP)
(74) Representative: J A Kemp LLP
(86) International application number: PCT/JP2021/013824
(87) International publication number: WO 2021/215210

(57) **Abstract**

To provide a metal complex which is useful for production of a light emitting device excellent in light emission efficiency.

A metal complex represented by the formula (1): 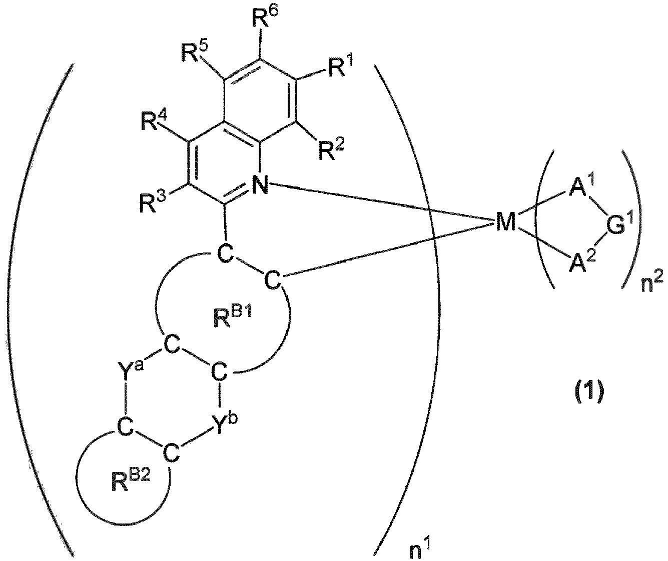 [wherein,
M represents a rhodium atom, a palladium atom, an iridium atom or a platinum atom; n¹ represents 1, 2 or 3; n² represents 0, 1 or 2; R¹ to R⁶ represent a hydrogen atom, an alkyl group, an aryl group and the like; Ring R^{B1} and Ring R^{B2} represent an aromatic hydrocarbon ring or an aromatic hetero ring.

One of Y^{a} and Y^{b} is a single bond, and the other is a group represented by the formula (C-1): 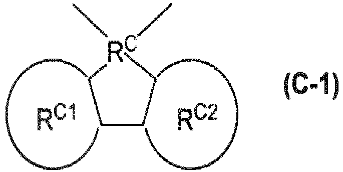 (wherein, R^{C} represents a carbon atom, a silicon atom, a germanium atom, a tin atom or a lead atom; Ring R^{C1} and Ring R^{c2} represent an aromatic hydrocarbon ring or an aromatic hetero ring.)

A¹-G¹-A² represents an anionic bidentate ligand.]

## Description

### Technical Field

The present invention relates to a metal complex, a composition containing the metal complex, and a light emitting device containing the metal complex.

### Background Art

Light emitting devices such as an organic electroluminescent device and the like can be suitably used for display and illumination applications, and are being researched and developed. As the light emitting material used for a light emitting device, for example, a metal complex 1 represented by the following formula is suggested in Patent Document 1.

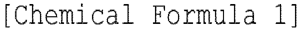

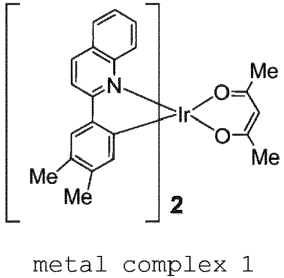

### Prior Art Document

### Patent Document

Patent Document 1: Japanese Translation of PCT International Application Publication (JP-T) No. 2010-520882

### Summary of the Invention

### Problem to be solved by the Invention

However, a light emitting device containing the above-described metal complex 1 was not sufficient in light emission efficiency.

Then, the present invention has an object of providing a metal complex which is useful for production of a light emitting device excellent in light emission efficiency. Further, the present invention has an object of providing a composition containing the metal complex and a light emitting device containing the metal complex.

### Means for solving the Problem

The present invention provides the following [1] to [8] .
[1] A metal complex represented by the formula (1): 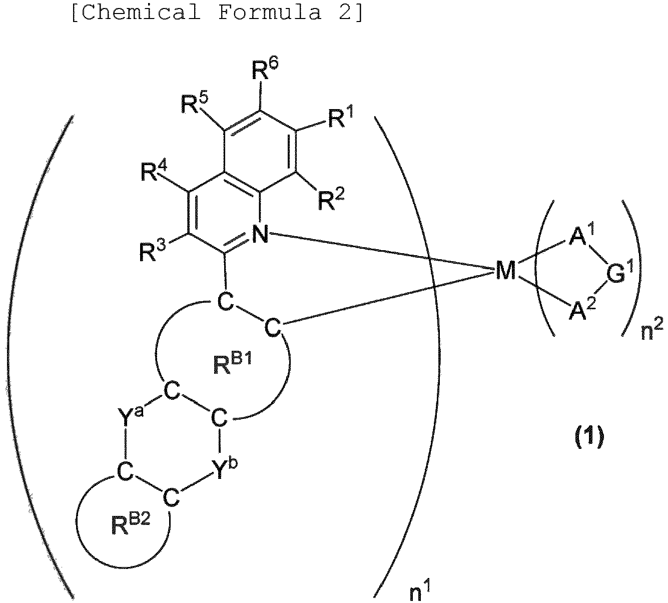 [wherein,
   M represents a rhodium atom, a palladium atom, an iridium atom or a platinum atom.
   n¹ represents 1, 2 or 3. n² represents 0, 1 or 2. n¹+n² is 3 when M is a rhodium atom or an iridium atom, while n¹+n² is 2 when M is a platinum atom or a palladium atom.
   R¹, R², R³, R⁴, R⁵ and R⁶ each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and these groups optionally have a substituent. When a plurality of the substituents are present, they may be combined together to form a ring together with atoms to which they are attached. When a plurality of R¹, R², R³, R⁴, R⁵ and R⁶ are present, they may be the same or different at each occurrence. R³ and R⁴, R⁴ and R⁵, R⁵ and R⁶, and R¹ and R² may each be combined together to form a ring together with carbon atoms to which they are attached.
   Ring R^{B1} and Ring R^{B2} each independently represent an aromatic hydrocarbon ring or an aromatic hetero ring, and these rings optionally have a substituent. When a plurality of the substituents are present, they may be combined together to form a ring together with atoms to which they are attached. The substituent which Ring R^{B1} optionally has and R³ may be combined together to form a ring together with atoms to which they are attached. When a plurality of Ring R^{B1} and Ring R^{B2} are present, they may be the same or different at each occurrence.
   One of Y^{a} and Y^{b} is a single bond, and the other is a group represented by the formula (C-1): 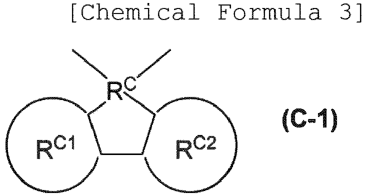 (wherein,
   R^{C} represents a carbon atom, a silicon atom, a germanium atom, a tin atom or a lead atom.
   Ring R^{C1} and Ring R^{C2} each independently represent an aromatic hydrocarbon ring or an aromatic hetero ring, and these rings optionally have a substituent. When a plurality of the substituents are present, they may be combined together to form a ring together with atoms to which they are attached. The substituent which Ring R^{C1} optionally has and the substituent which Ring R^{C2} optionally has may be combined together to form a ring together with atoms to which they are attached.). When a plurality of Y^{a} and Y^{b} are present, they may be the same or different at each occurrence.
   A¹-G¹-A² represents an anionic bidentate ligand, and G¹ represents an atomic group constituting a bidentate ligand together with A¹ and A². A¹ and A² each independently represent a carbon atom, an oxygen atom or a nitrogen atom, and these atoms may be ring-constituent atoms. When a plurality of A¹-G¹-A² are present, they may be the same or different.] .
[2] The metal complex according to [1], wherein the metal complex represented by the above-described formula (1) is a metal complex represented by the formula (1-A1), the formula (1-A2) or the formula (1-A3): 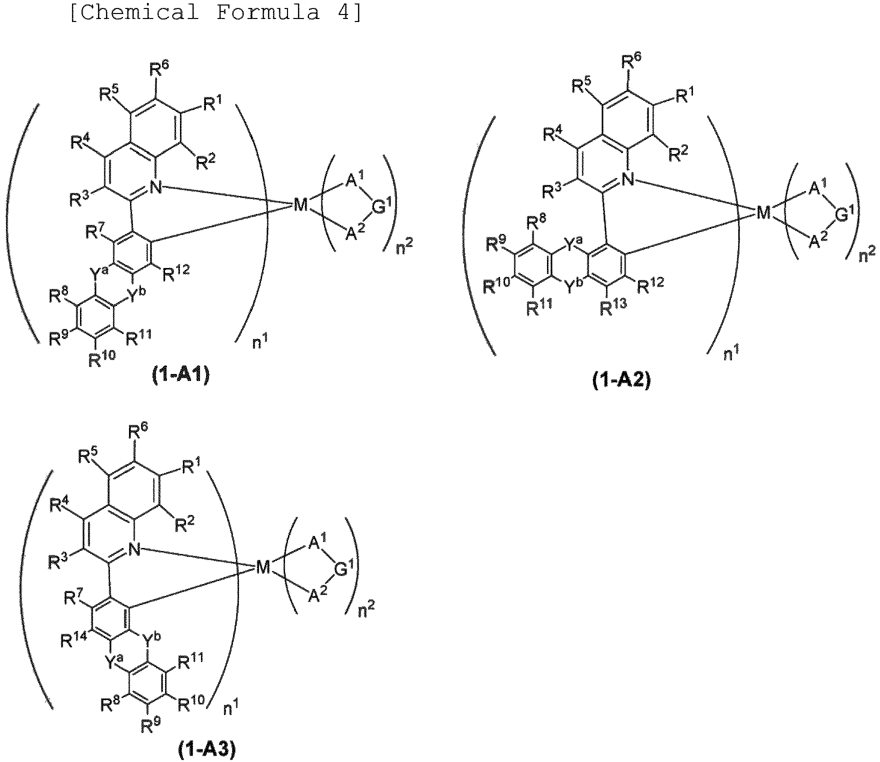 [wherein,
   M, n¹ , n² , R¹ , R², R³, R⁴, R⁵, R⁶, Y^{a} , Y^{b} and A¹-G¹-A² represent the same meaning as described above.
   R⁷, R⁸, R⁹, R¹⁰, R¹¹, R¹² , R¹³ and R¹⁴ each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and these groups optionally have a substituent. When a plurality of the substituents are present, they may be combined together to form a ring together with atoms to which they are attached. When a plurality of R⁷, R⁸, R⁹, R¹⁰ , R¹¹ , R¹², R¹³ and R¹⁴ are present, they may be the same or different at each occurrence. R⁸ and R⁹, R⁹ and R¹⁰ , R¹⁰ and R¹¹ , R¹² and R¹³ , R⁷ and R¹⁴, and R⁷ and R³ may each be combined together to form a ring together with atoms to which they are attached.].
[3] The metal complex according to [1] or [2], wherein the group represented by the above-described formula (C-1) is a group represented by the formula (C-2): 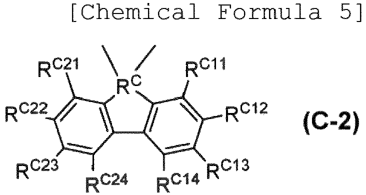 [wherein,
   R^{C} represents the same meaning as described above.
   R^{C11}, R^{C12}, R^{C13}, R^{C14}, R^{C21}, R^{C22}, R^{C23} and R^{C24} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and these groups optionally have a substituent. When a plurality of the substituents are present, they may be combined together to form a ring together with atoms to which they are attached. When a plurality of R^{C11}, R^{C12}, R^{C13}, R^{C14}, R^{C21}, R^{C22}, R^{C23} and R^{C24} are present, they may be the same or different at each occurrence. R^{C11} and R^{C12}, R^{C12} and R^{C13} , R^{C13} and R^{C14} , R^{C14} and R^{C24}, R^{C24} and R^{C23}, R^{C23} and R^{C22}, and R^{C22} and R^{C21} may each be combined together to form a ring together with atoms to which they are attached.].
[4] The metal complex according to [3], wherein the metal complex represented by the above-described formula (1) is a metal complex represented by the formula (1-A1-1): 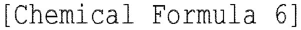 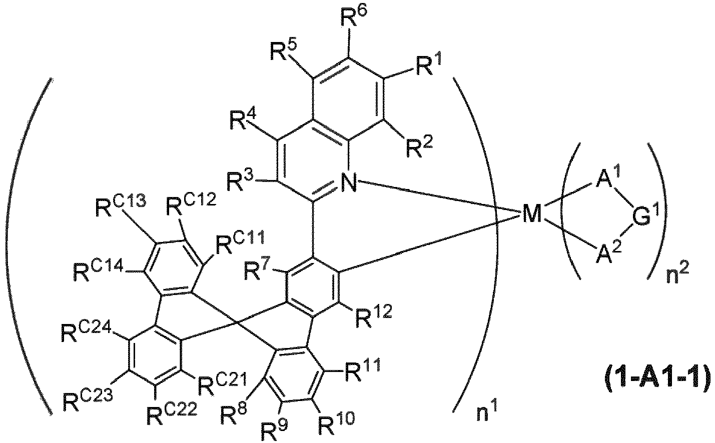 [wherein,
   M, n¹, n², R¹, R², R³, R⁴, R⁵ , R⁶ , R^{C11}, R^{C12}, R^{C13}, R^{C14}, R^{C21}, R^{C22}, R^{C23}, R^{C24} and A¹-G¹-A² represent the same meaning as described above.
   R⁷, R⁸, R⁹, R¹⁰ , R¹¹ and R¹² each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and these groups optionally have a substituent. When a plurality of the substituents are present, they may be combined together to form a ring together with atoms to which they are attached. When a plurality of R⁷, R⁸, R⁹, R¹⁰ , R¹¹ and R¹² are present, they may be the same or different at each occurrence. R⁸ and R⁹ , R⁹ and R¹⁰ , R¹⁰ and R¹¹ , and R⁷ and R³ may each be combined together to form a ring together with atoms to which they are attached.].
[5] The metal complex according to any one of [1] to [4], wherein the above-described n² is 0.
[6] A composition comprising the metal complex as described in any one of [1] to [5], and at least one selected from the group consisting of a hole transporting material, a hole injection material, an electron transporting material, an electron injection material, a light emitting material, an antioxidant and a solvent.
[7] A composition comprising the metal complex as described in any one of [1] to [5], and at least one selected from the group consisting of a compound represented by the formula (H-1) and a polymer compound having a constitutional unit represented by the formula (Y) : 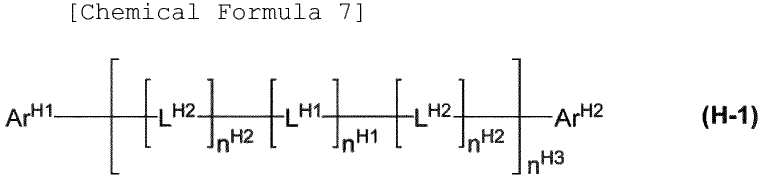 [wherein,
   Ar^{H1} and Ar^{H2} each independently represent an aryl group or a monovalent hetero ring group, and these groups optionally have a substituent.
   n^{H1} and n^{H2} each independently represent 0 or 1. When a plurality of n^{H1} are present, they may be the same or different. A plurality of n^{H2} may be the same or different.
   n^{H3} represents an integer of 0 or more.
   L^{H1} represents an arylene group, a divalent hetero ring group or a group represented by -[C(R^{H11})₂]n^{H11}-, and these groups optionally have a substituent. When a plurality of L^{H1} are present, they may be the same or different. n^{H11} represents an integer of 1 or more and 10 or less. R^{H11} represents a hydrogen atom, an alkyl group, a cycloalkyl group, an alkoxy group, a cycloalkoxy group, an aryl group or a monovalent hetero ring group, and these groups optionally have a substituent. A plurality of R^{H11} may be the same or different and may be combined together to form a ring together with carbon atoms to which they are attached.
   L^{H2} represents a group represented by -N(R^{H21})-. When a plurality of L^{H2} are present, they may be the same or different. R^{H21} represents a hydrogen atom, an alkyl group, a cycloalkyl group, an aryl group or a monovalent hetero ring group, and these groups optionally have a substituent.] 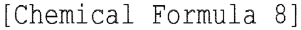 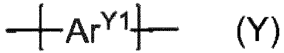 [wherein, Ar^{Y1} represents an arylene group, a divalent hetero ring group or a divalent group in which an arylene group and a divalent hetero ring group are bonded directly, and these groups optionally have a substituent.].
[8] A light emitting device comprising the metal complex as described in any one of [1] to [5].

### Effect of the Invention

According to the present invention, it is possible to provide a metal complex which is useful for production of a light emitting device excellent in light emission efficiency. Further, according to the present invention, it is possible to provide a composition containing the metal complex, and a light emitting device containing the metal complex.

### Modes for Carrying Out the Invention

Suitable embodiments of the present invention will be illustrated in detail below.

<Explanation of common terms>

Terms commonly used in the present specification have the following meanings unless otherwise stated.

Me represents a methyl group, Et represents an ethyl group, Bu represents a butyl group, i-Pr represents an isopropyl group, and t-Bu represents a tert-butyl group.

A hydrogen atom may be a heavy hydrogen atom, or may be a light hydrogen atom.

In the formula representing a metal complex, a solid line representing a bond with the central metal means a covalent bond or a coordinate bond.

The "low molecular compound" means a compound having no molecular weight distribution and having a molecular weight of 1×10⁴ or less.

The "polymer compound" means a polymer having molecular weight distribution and having a polystyrene-equivalent number-average molecular weight of 1×10³ or more (for example, 1×10³ to 1×10⁸).

The "constitutional unit" means a unit occurring once or more times in a polymer compound. A constitutional unit occurring twice or more times in a polymer compound is generally referred to also as "repeating unit".

The polymer compound may be any of a block copolymer, a random copolymer, an alternative copolymer, or a graft copolymer, and may also be in another form.

The end group of the polymer compound is preferably a stable group since if a polymerization active group remains intact there, there is a possibility of a decrease in a light emitting property and the like of a light emitting device when the polymer compound is used for fabrication of the light emitting device. The end group of the polymer compound is preferably a group conjugatively bonded to the main chain and includes, for example, an aryl group or a monovalent hetero ring group bonding to the main chain of the polymer compound via a carbon-carbon bond.

The "alkyl group" may be any of linear or branched. The number of carbon atoms of the linear alkyl group is, not including the number of carbon atoms of the substituent, usually 1 to 50, preferably 1 to 30, and more preferably 1 to 20. The number of carbon atoms of the branched alkyl group is, not including the number of carbon atoms of the substituent, usually 3 to 50, preferably 3 to 30, and more preferably 4 to 20.

The alkyl group optionally has a substituent. The alkyl group includes, for example, a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group. Further, the alkyl group may also be a group obtained by substituting a part or all of hydrogen atoms in these groups with a cycloalkyl group, an alkoxy group, a cycloalkoxy group, an aryl group, a fluorine atom or the like. Such an alkyl group includes, for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group and a 6-ethyloxyhexyl group.

The number of carbon atoms of the "cycloalkyl group" is, not including the number of carbon atoms of the substituent, usually 3 to 50, preferably 3 to 30, and more preferably 4 to 20. The cycloalkyl group optionally has a substituent. The cycloalkyl group includes, for example, a cyclohexyl group, a cyclohexylmethyl group, and a cyclohexylethyl group.

The "aryl group" means an atomic group remaining after removing from an aromatic hydrocarbon one hydrogen atom bonding directly to a carbon atom constituting the ring. The number of carbon atoms of the aryl group is, not including the number of carbon atoms of the substituent, usually 6 to 60, preferably 6 to 20, and more preferably 6 to 10.

The aryl group optionally has a substituent. The aryl group includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group. Further, the aryl group may also be a group obtained by substituting a part or all of hydrogen atoms in these groups with an alkyl group, a cycloalkyl group, an alkoxy group, a cycloalkoxy group, an aryl group, a fluorine atom and the like.

The "arylene group" means an atomic group remaining after removing from an aromatic hydrocarbon two hydrogen atoms bonding directly to carbon atoms constituting the ring. The number of carbon atoms of the arylene group is, not including the number of carbon atoms of the substituent, usually 6 to 60, preferably 6 to 30, and more preferably 6 to 18.

The arylene group optionally has a substituent. The arylene group includes, for example, a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group and a chrysenediyl group, and groups obtained by substituting a part or all of hydrogen atoms in these groups with a substituent. The arylene group is preferably a group represented by the formula (A-1) to the formula (A-20). The arylene group includes groups obtained by bonding a plurality of these groups. 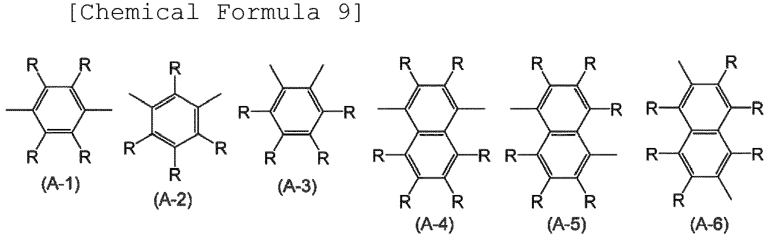 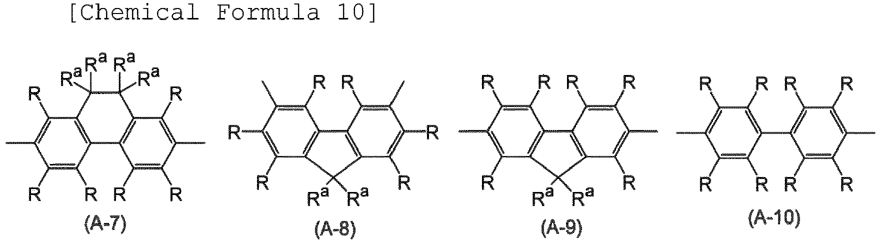 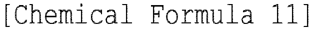 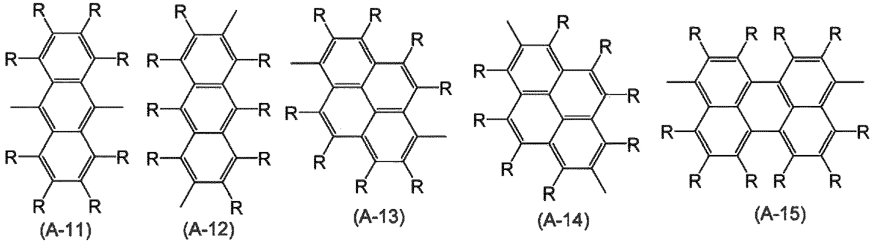 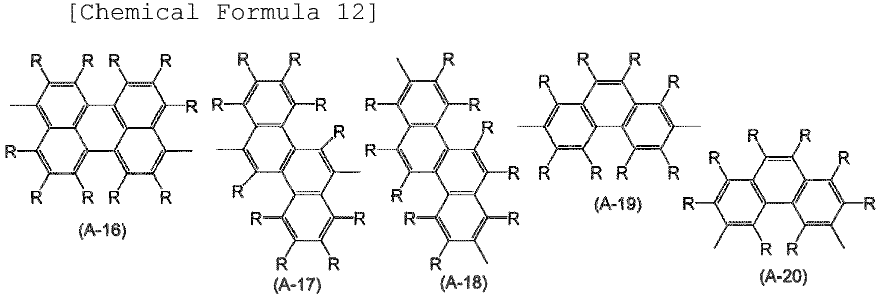 (wherein, R and R^{a} each independently represent a hydrogen atom, an alkyl group, a cycloalkyl group, an aryl group or a monovalent hetero ring group. A plurality of R and R^{a} may be the same or different at each occurrence, and groups R^{a} may be combined together to form a ring together with atoms to which they are attached.)

The "alkoxy group" may be any of linear or branched. The number of carbon atoms of the linear alkoxy group is, not including the number of carbon atoms of the substituent, usually 1 to 40, and preferably 1 to 10. The number of carbon atoms of the branched alkoxy group is, not including the number of carbon atoms of the substituent, usually 3 to 40, and preferably 4 to 10.

The alkoxy group optionally has a substituent. The alkoxy group includes, for example, a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group, and a lauryloxy group. Further, the alkoxy group may also be a group obtained by substituting a part or all of hydrogen atoms in these groups with a cycloalkyl group, an alkoxy group, a cycloalkoxy group, an aryl group, a fluorine atom or the like.

The number of carbon atoms of the "cycloalkoxy group" is, not including the number of carbon atoms of the substituent, usually 3 to 40, and preferably 4 to 10.

The cycloalkoxy group optionally has a substituent. The cycloalkoxy group includes, for example, a cyclohexyloxy group.

The number of carbon atoms of the "aryloxy group" is, not including the number of carbon atoms of the substituent, usually 6 to 60, and preferably 6 to 48.

The aryloxy group optionally has a substituent. The aryloxy group includes, for example, a phenoxy group, a 1-naphthyloxy group, a 2-naphthyloxy group, a 1-anthracenyloxy group, a 9-anthracenyloxy group, and a 1-pyrenyloxy group. Further, the aryloxy group may also be a group obtained by substituting a part of all of hydrogen atoms in these groups with an alkyl group, a cycloalkyl group, an alkoxy group, a cycloalkoxy group, a fluorine atom or the like.

The "p-valent hetero ring group" (p represents an integer of 1 or more) means an atomic group remaining after removing from a heterocyclic compound p hydrogen atoms among hydrogen atoms bonding directly to carbon atoms or hetero atoms constituting the ring. Of p-valent hetero ring groups, "p-valent aromatic hetero ring group" which is an atomic group remaining after removing from an aromatic heterocyclic compound p hydrogen atoms among hydrogen atoms bonding directly to carbon atoms or hetero atoms constituting the ring is preferred.

The "aromatic heterocyclic compound" includes, for example, compounds in which the hetero ring itself shows aromaticity, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole, and the like, and compounds in which an aromatic ring is condensed to the hetero ring even if the hetero ring itself shows no aromaticity, such as phenoxazine, phenothiazine, dibenzoborole, dibenzosilole, benzopyran, and the like.

The number of carbon atoms of the monovalent hetero ring group is, not including the number of carbon atoms of the substituent, usually 2 to 60, and preferably 4 to 20.

The monovalent hetero ring group optionally has a substituent. The monovalent hetero ring group includes, for example, a thienyl group, a pyrrolyl group, a furyl group, a pyridinyl group, a piperidinyl group, a quinolinyl group, an isoquinolinyl group, a pyrimidinyl group and a triazinyl group. Further, the monovalent hetero ring group may also be a group obtained by substituting a part or all of hydrogen atoms in these groups with an alkyl group, a cycloalkyl group, an alkoxy group, a cycloalkoxy group or the like.

The number of carbon atoms of the divalent hetero ring group is, not including the number of carbon atoms of the substituent, usually 2 to 60, preferably 3 to 20, and more preferably 4 to 15.

The divalent hetero ring group optionally has a substituent. The divalent hetero ring group includes, for example, divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole or a triazole two hydrogen atoms among hydrogen atoms bonding directly to carbon atoms or hetero atoms constituting the ring. Further, the divalent hetero ring group may also be a group obtained by substituting a part or all of hydrogen atoms in these groups with a substituent. The divalent hetero ring group is preferably a group represented by the formula (AA-1) to formula (AA-34). The divalent hetero ring group includes groups in which multiple of these groups are bonded. 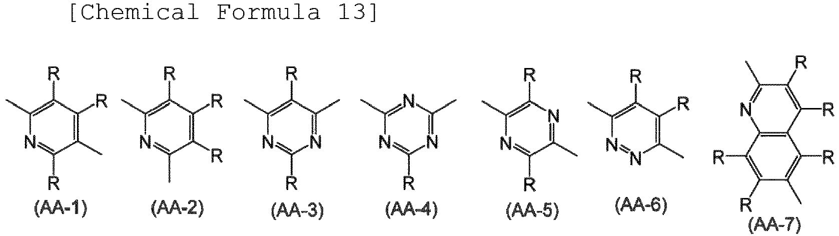 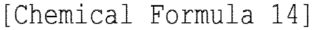 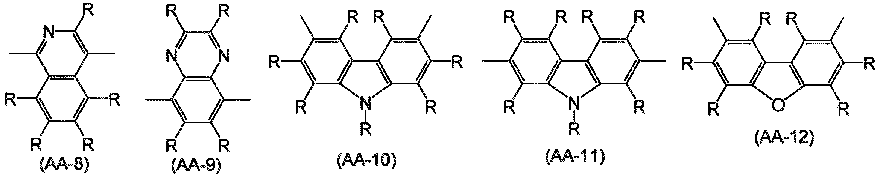 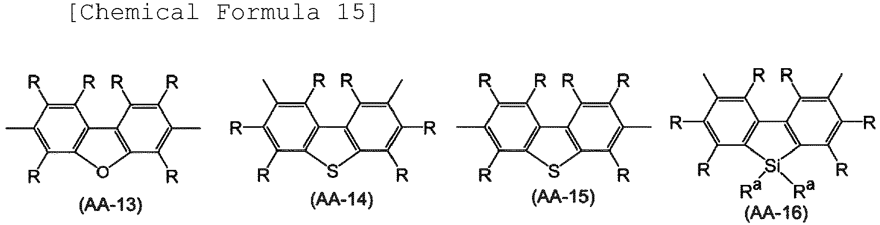 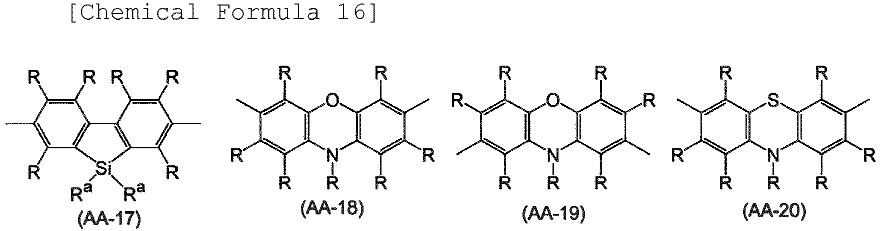 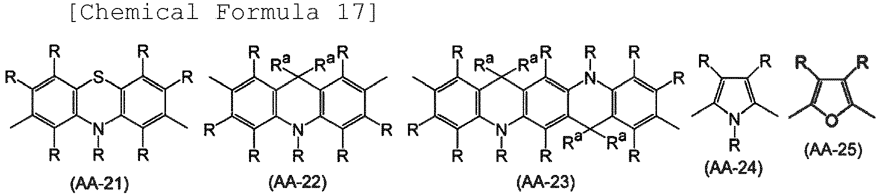 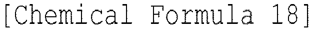 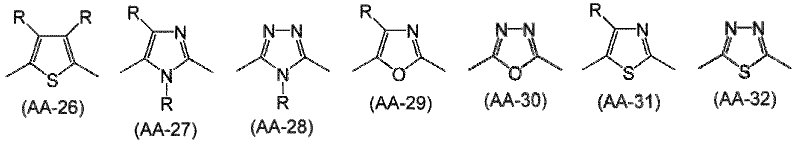 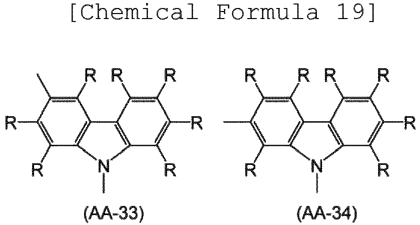 (wherein, R and Ra represent the same meaning as described above.)

"The halogen atom" denotes a fluorine atom, a chlorine atom, a bromine atom or an iodine atom.

"The amino group" optionally has a substituent, and is preferably a substituted amino group (preferably a secondary amino group or a tertiary amino group, and more preferably a tertiary amino group). As the substituent which an amino group has, an alkyl group, a cycloalkyl group, an aryl group or a monovalent hetero ring group is preferred. When a plurality of the substituents which an amino group has are present, they may be the same or different and may be combined together to form a ring together with a nitrogen atom to which they are attached.

The substituted amino group includes, for example, a dialkylamino group (for example, a dimethylamino group, a diethylamino group), a dicycloalkylamino group, a diarylamino group (for example, a diphenylamino group), a bis(4-methylphenyl)amino group, a bis(4-tert-butylphenyl)amino group, and a bis(3,5-di-tert-butylphenyl)amino group.

"The alkenyl group" may be any of linear or branched. The number of carbon atoms of the linear alkenyl group is, not including the number of carbon atoms of the substituent, usually 2 to 30, and preferably 3 to 20. The number of carbon atoms of the branched alkenyl group is, not including the number of carbon atoms of the substituent, usually 3 to 30, and preferably 4 to 20.

The number of carbon atoms of "the cycloalkenyl group" is, not including the number of carbon atoms of the substituent, usually 3 to 30, and preferably 4 to 20.

The alkenyl group and the cycloalkenyl group optionally have a substituent. The alkenyl group includes, for example, a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group, and a group obtained by substituting a part or all of hydrogen atoms in these groups with a substituent. The cycloalkenyl group includes, for example, a cyclohexenyl group, a cyclohexadienyl group, a cyclooctatrienyl group and a norbornylenyl group, and a group obtained by substituting a part or all of hydrogen atoms in these groups with a substituent.

"The alkynyl group" may be any of linear or branched. The number of carbon atoms of the linear alkynyl group is, not including carbon atoms of the substituent, usually 2 to 20, and preferably 3 to 20. The number of carbon atoms of the branched alkynyl group is, not including carbon atoms of the substituent, usually 4 to 30, and preferably 4 to 20.

The number of carbon atoms of "the cycloalkynyl group" is, not including carbon atoms of the substituent, usually 4 to 30, and preferably 4 to 20.

The alkynyl group and the cycloalkynyl group optionally have a substituent. The alkynyl group includes, for example, an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and a group obtained by substituting a part or all of hydrogen atoms in these groups with a substituent. The cycloalkynyl group includes, for example, a cyclooctynyl group, and a group obtained by substituting a part or all of hydrogen atoms in these groups with a substituent.

The "cross-linkable group" is a group capable of generating a new bond by being subjected to heating, irradiation with ultraviolet light, irradiation with near-ultraviolet light, irradiation with visible light, irradiation with infrared light, radical reaction, and the like. The cross-linkable group is preferably a group represented by any of the formula (B-1) to the formula (B-18). These groups optionally have a substituent, and substituents which respective groups have may be combined together to form a ring.

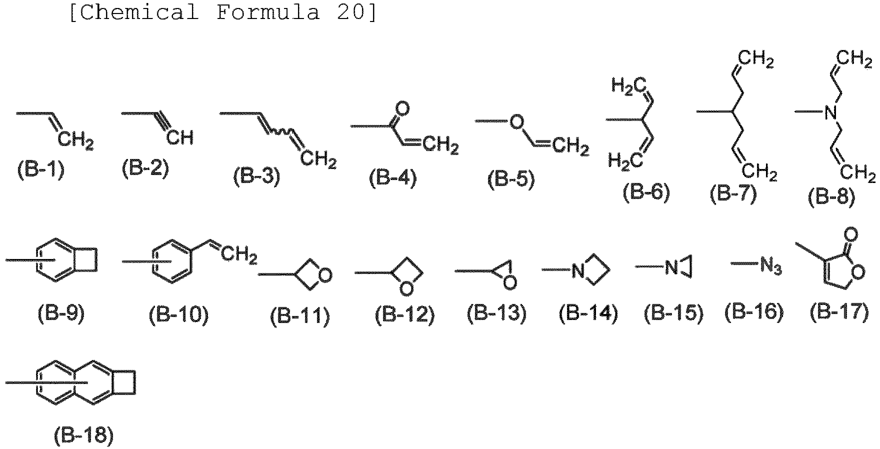

The "substituent" denotes a halogen atom, a cyano group, an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group or a cycloalkynyl group. The substituent may be a cross-linkable group.

### <Metal complex>

The metal complex of the present embodiment is a metal complex represented by the formula (1). The metal complex represented by the formula (1) is usually a metal complex showing phosphorescence (preferably red phosphorescence) at room temperature (25°C), and preferably a metal complex showing light emission from the triplet excited state at room temperature. The metal complex represented by the formula (1) is constituted of a central metal M, a ligand of which number is defined by index n¹, and a ligand of which number is defined by index n².

The metal complex of the present embodiment is preferably a phosphorescent complex, and more preferably a red phosphorescent complex. The substituent which each group has in the metal complex of the present embodiment is preferably selected in a range wherein the metal complex of the present embodiment has phosphorescence, and more preferably selected in a range wherein the metal complex of the present embodiment has red phosphorescence.

M is preferably an iridium atom or a platinum atom, and more preferably an iridium atom, since the light emitting device using the metal complex of the present embodiment (hereinafter, referred to also as "the light emitting device of the present embodiment") is excellent in light emission efficiency.

n² is preferably 0 or 1, and more preferably 0 (in other words, for example, when M is an iridium atom, then, n¹ is 3), since the light emitting device of the present embodiment is excellent in light emission efficiency.

R¹ to R⁶ are each preferably a hydrogen atom, an alkyl group, a cycloalkyl group, an aryl group, a monovalent hetero ring group or a substituted amino group, more preferably a hydrogen atom, an alkyl group, a cycloalkyl group, an aryl group or a monovalent hetero ring group, further preferably a hydrogen atom, an aryl group or a monovalent hetero ring group, and particularly preferably a hydrogen atom or an aryl group, since the light emitting device of the present embodiment is excellent in light emission efficiency, and these groups optionally have a substituent.

It is preferable that at least one of R¹ to R⁶ is an aryl group or a monovalent hetero ring group, it is more preferable that at least one of R¹ to R⁶ is an aryl group, it is further preferable that at least one of R⁵ and R⁶ is an aryl group, and it is particularly preferable that R⁶ is an aryl group, since the light emitting device of the present embodiment is more excellent in light emission efficiency, and these groups optionally have a substituent.

The aryl group for R¹ to R⁶ is preferably a phenyl group, a naphthyl group, an anthracenyl group, a phenanthrenyl group, a dihydrophenanthrenyl group, a fluorenyl group, a spirobifluorenyl group or a pyrenyl group, more preferably a phenyl group, a naphthyl group or a fluorenyl group, and further preferably a phenyl group, and these groups optionally have a substituent.

The monovalent hetero ring group for R¹ to R⁶ is preferably a pyridyl group, a pyrimidinyl group, a triazinyl group, a quinolinyl group, an isoquinolinyl group, a dibenzofuranyl group, a dibenzothienyl group, a carbazolyl group, an azacarbazolyl group, a diazacarbazolyl group, a phenoxazinyl group or a phenothiazinyl group, more preferably a pyridyl group, a pyrimidinyl group, a triazinyl group, a dibenzofuranyl group, a carbazolyl group, an azacarbazolyl group or a diazacarbazolyl group, and further preferably a pyridyl group, a pyrimidinyl group or a triazinyl group, and these groups optionally have a substituent.

In the substituted amino group for R¹ to R⁶, the substituent which an amino group has is preferably an aryl group or a monovalent hetero ring group, and more preferably an aryl group, and these groups optionally further have a substituent. The examples and preferable range of the aryl group as the substituent which an amino group has are the same as the examples and preferable range of the aryl group for R¹ to R⁶. The examples and preferable range of the monovalent hetero ring group as the substituent which an amino group has are the same as the examples and preferable range of the monovalent hetero ring group for R¹ to R⁶.

The substituent which R¹ to R⁶ optionally have is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group, a monovalent hetero ring group or a substituted amino group, further preferably an alkyl group, a cycloalkyl group or an aryl group, and particularly preferably an alkyl group or a cycloalkyl group, and these groups optionally further have a substituent.

The examples and preferable ranges of the aryl group, the monovalent hetero ring group and the substituted amino group as the substituent which R¹ to R⁶ optionally have are the same as the examples and preferable ranges of the aryl group, the monovalent hetero ring group and the substituted amino group for R¹ to R⁶, respectively.

The substituent which the substituent which R¹ to R⁶ optionally have optionally further has is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group, a monovalent hetero ring group or a substituted amino group, further preferably an alkyl group or a cycloalkyl group, and particularly preferably an alkyl group, and these groups optionally further have a substituent, but it is preferable that they do not further have a substituent.

The examples and preferable ranges of the aryl group, the monovalent hetero ring group and the substituted amino group as the substituent which the substituent which R¹ to R⁶ optionally have optionally further has are the same as the examples and preferable ranges of the aryl group, the monovalent hetero ring group and the substituted amino group for R¹ to R⁶, respectively.

R³ and R⁴, R⁴ and R⁵, R⁵ and R⁶, and R¹ and R² may each be combined together to form a ring together with carbon atoms to which they are attached. This ring can also be said to be a ring obtained by removing a hydrogen atom in one group and a hydrogen atom in another group, and combining atoms to which the respective hydrogen atoms are attached. For example, when both R³ and R⁴ are alkyl groups, R³ and R⁴ may form a ring obtained by removing a hydrogen atom in each alkyl group, and combining carbon atoms to which the removed hydrogen atoms are attached.

It is preferable that Y^{b} is a single bond, and Y^{a} is a group represented by the formula (C-1), since the light emitting device of the present embodiment is excellent in light emission efficiency.

In Ring R^{B1}, Ring R^{B2}, Ring R^{C1} and Ring R^{C2}, the number of carbon atoms of the aromatic hydrocarbon ring is, not including the number of carbon atoms of the substituent, usually 6 to 60, preferably 6 to 30, more preferably 6 to 18, and further preferably 6 to 10.

The aromatic hydrocarbon ring for Ring R^{B1}, Ring R^{B2}, Ring R^{C1} and Ring R^{C2} includes, for example, a benzene ring, a naphthalene ring, an anthracene ring, an indene ring, a fluorene ring, a spirobifluorene ring, a phenanthrene ring, a dihydrophenanthrene ring, a pyrene ring, a chrysene ring and a triphenylene ring, and is preferably a benzene ring, a naphthalene ring, an anthracene ring, a fluorene ring, a spirobifluorene ring, a phenanthrene ring or a dihydrophenanthrene ring, more preferably a benzene ring, a naphthalene ring, a fluorene ring or a spirobifluorene ring, and further preferably a benzene ring, and these rings optionally have a substituent.

In Ring R^{B1}, Ring R^{B2}, Ring R^{C1} and Ring R^{C2}, the number of carbon atoms of the aromatic hetero ring is, not including the number of carbon atoms of the substituent, usually 2 to 60, preferably 3 to 30, and more preferably 4 to 15.

The aromatic hetero ring for Ring R^{B1}, Ring R^{B2}, Ring R^{C1} and Ring R^{C2} includes, for example, a pyrrole ring, a diazole ring, a triazole ring, a furan ring, a thiophene ring, an oxadiazole ring, a thiadiazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring, a triazaphenanthrene ring, a dibenzofuran ring, a dibenzothiophene ring, a dibenzosilole ring, a dibenzophosphole ring, a carbazole ring, an azacarbazole ring, a diazacarbazole ring, a phenoxazine ring, a phenothiazine ring, a dihydroacridine ring and a dihydrophenazine ring, and is preferably a pyridine ring, a diazabenzene ring, an azanaphthalene ring, a diazanaphthalene ring, an azaanthracene ring, a diazaphenanthrene ring, a dibenzofuran ring, a dibenzothiophene ring, a carbazole ring, a phenoxazine ring, a phenothiazine ring, a dihydroacridine ring or a dihydrophenazine ring, more preferably a pyridine ring, a diazabenzene ring, an azanaphthalene ring, a diazanaphthalene ring, a dibenzofuran ring, a dibenzothiophene ring or a carbazole ring, and further preferably a pyridine ring or a diazabenzene ring, and these rings optionally have a substituent.

It is preferable that at least one of Ring R^{B1}, Ring R^{B2}, Ring R^{C1} and Ring R^{C2} is an aromatic hydrocarbon ring, it is more preferable that at least two or more of Ring R^{B1}, Ring R^{B2}, Ring R^{C1} and Ring R^{C2} are aromatic hydrocarbon rings, and it is further preferable that all of Ring R^{B1}, Ring R^{B2}, Ring R^{C1} and Ring R^{C2} are aromatic hydrocarbon rings, since the light emitting device of the present embodiment is excellent in light emission efficiency, and these rings optionally have a substituent.

The substituent which Ring R^{B1}, Ring R^{B2}, Ring R^{C1} and Ring R^{C2} optionally have is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group, a monovalent hetero ring group or a substituted amino group, further preferably an alkyl group, a cycloalkyl group, an aryl group or a monovalent hetero ring group, and particularly preferably an alkyl group, a cycloalkyl group or an aryl group, and these groups optionally further have a substituent.

The examples and preferable ranges of the aryl group, the monovalent hetero ring group and the substituted amino group as the substituent which Ring R^{B1}, Ring R^{B2}, Ring R^{C1} and Ring R^{C2} optionally have are the same as the examples and preferable ranges of the aryl group, the monovalent hetero ring group and the substituted amino group for R¹ to R⁶, respectively.

The examples and preferable range of the substituent which the substituent which Ring R^{B1}, Ring R^{B2}, Ring R^{C1} and Ring R^{C2} optionally have optionally further has are the same as the examples and preferable range of the substituent which R¹ to R⁶ optionally have.

R^{C} is preferably a carbon atom, a silicon atom or a germanium atom, more preferably a carbon atom or a silicon atom, and further preferably a carbon atom, since the light emitting device of the present embodiment is excellent in light emission efficiency.

The group represented by the formula (C-1) is preferably a group represented by the formula (C-2), since the light emitting device of the present embodiment is excellent in light emission efficiency.

R^{C11} to R^{C14} and R^{C21} to R^{C24} are each preferably a hydrogen atom, an alkyl group, a cycloalkyl group, an aryl group, a monovalent hetero ring group or a substituted amino group, more preferably a hydrogen atom, an alkyl group, a cycloalkyl group or an aryl group, further preferably a hydrogen atom, an alkyl group or an aryl group, and particularly preferably a hydrogen atom, since the present embodiment is excellent in light emission efficiency, and these groups optionally have a substituent.

The examples and preferable ranges of the aryl group, the monovalent hetero ring group and the substituted amino group for R^{C11} to R^{C14} and R^{C21} to R^{C24} are the same as the examples and preferable ranges of the aryl group, the monovalent hetero ring group and the substituted amino group for R¹ to R⁶, respectively.

The examples and preferable range of the substituent which R^{C11} to R^{C14} and R^{C21} to R^{C24} optionally have are the same as the examples and preferable range of the substituent which R¹ to R⁶ optionally have.

The metal complex represented by the formula (1) is preferably a metal complex represented by the formula (1-A1), the formula (1-A2) or the formula (1-A3), and more preferably a metal complex represented by the formula (1-A1), since the light emitting device of the present embodiment is excellent in light emission efficiency.

R⁷ to R¹⁴ are each preferably a hydrogen atom, an alkyl group, a cycloalkyl group, an aryl group, a monovalent hetero ring group or a substituted amino group, more preferably a hydrogen atom, an alkyl group, a cycloalkyl group or an aryl group, further preferably a hydrogen atom, an alkyl group or an aryl group, and particularly preferably a hydrogen atom, since the light emitting device of the present embodiment is excellent in light emission efficiency, and these groups optionally have a substituent.

The examples and preferable ranges of the aryl group, the monovalent hetero ring group and the substituted amino group for R⁷ to R¹⁴ are the same as the examples and preferable ranges of the aryl group, the monovalent hetero ring group and the substituted amino group for R¹ to R⁶, respectively.

The examples and preferable range of the substituent which R⁷ to R¹⁴ optionally have are the same as the examples and preferable range of the substituent which R¹ to R⁶ optionally have.

The metal complex represented by the formula (1-A1) is preferably a metal complex represented by the formula (1-A1-1), since the light emitting device of the present embodiment is excellent in light emission efficiency.

### ● Anionic bidentate ligand

The anionic bidentate ligand represented by A¹-G¹-A² includes, for example, ligands represented by the following formulae. However, the anionic bidentate ligand represented by A¹-G¹-A² is different from a ligand of which number is defined by index n¹. 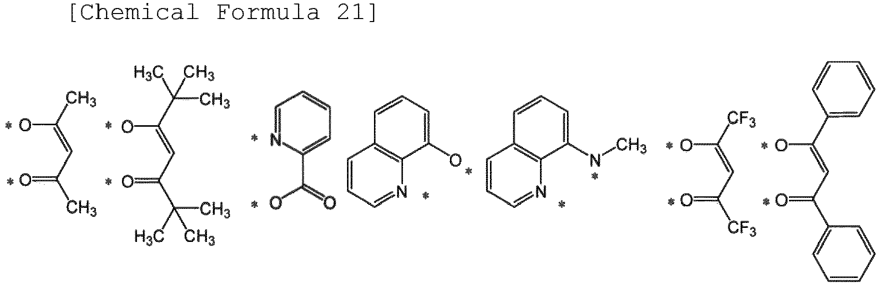 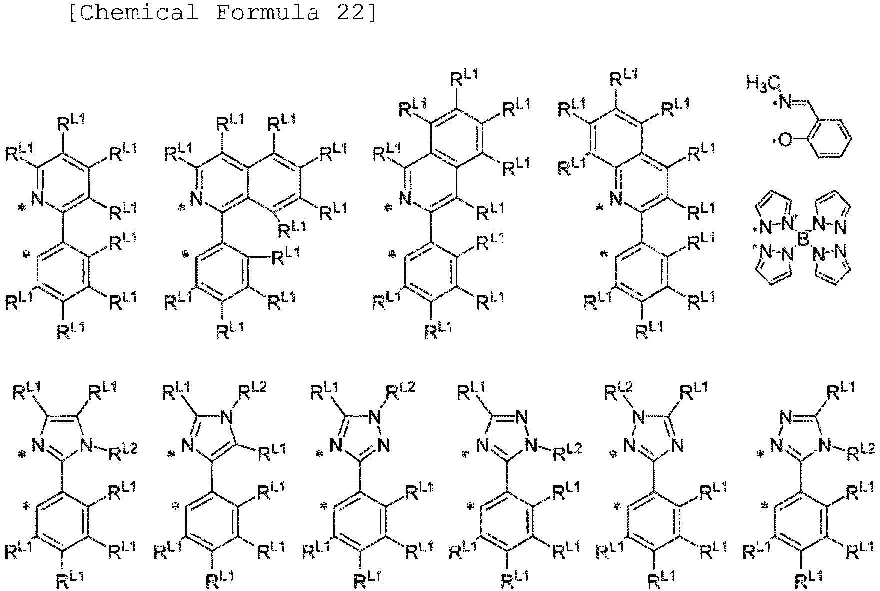 [wherein,
* represents a site binding to M.
R^{L1} represents a hydrogen atom, an alkyl group, a cycloalkyl group, an aryl group, a monovalent hetero ring group or a halogen atom, and these groups optionally have a substituent. A plurality of R^{L1} may be the same or different.
R^{L2} represents an alkyl group, a cycloalkyl group, an aryl group, a monovalent hetero ring group or a halogen atom, and these groups optionally have a substituent.]
R^{L1} is preferably a hydrogen atom, an alkyl group, a cycloalkyl group, an aryl group or a fluorine atom, and more preferably a hydrogen atom or an alkyl group, and these groups optionally have a substituent.
R^{L2} is preferably an alkyl group or an aryl group, and these groups optionally have a substituent.

The substituent which R^{L1} optionally has is preferably an alkyl group, a cycloalkyl group or an aryl group, and more preferably an alkyl group or an aryl group, and these groups optionally further have a substituent.

The substituent which the substituent which R^{L1} optionally has optionally further has is more preferably an alkyl group, a cycloalkyl group or an aryl group, and more preferably an alkyl group or an aryl group, and these groups optionally further have a substituent, but it is preferable that they do not further have a substituent.

The substituent which R^{L2} optionally has is preferably an alkyl group, a cycloalkyl group or an aryl group, and more preferably an alkyl group or an aryl group, and these groups optionally further have a substituent.

The substituent which the substituent which R^{L2} optionally has optionally further has is preferably an alkyl group, a cycloalkyl group or an aryl group, and more preferably an alkyl group or an aryl group, and these groups optionally further have a substituent, but it is preferable that they do not further have a substituent.

Specific examples of the metal complex represented by the formula (1) include metal complexes represented by the formula (Ir-101) to the formula (Ir-124).

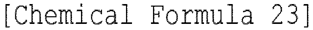

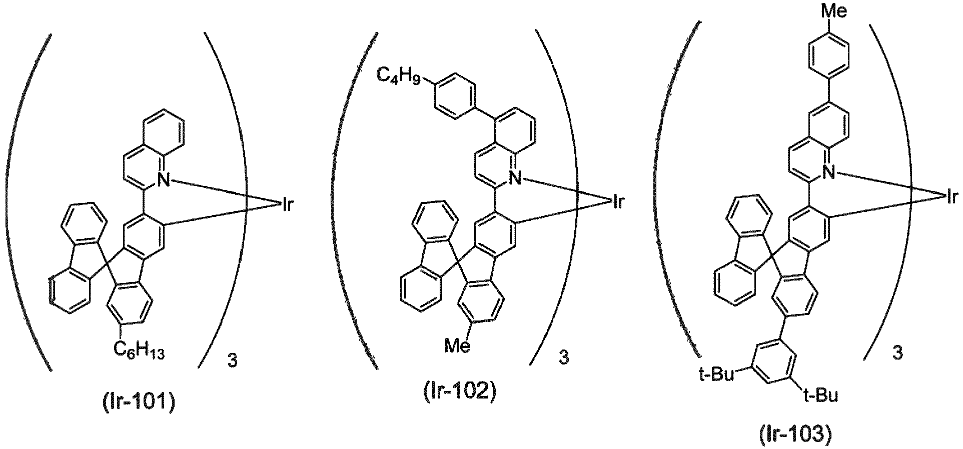

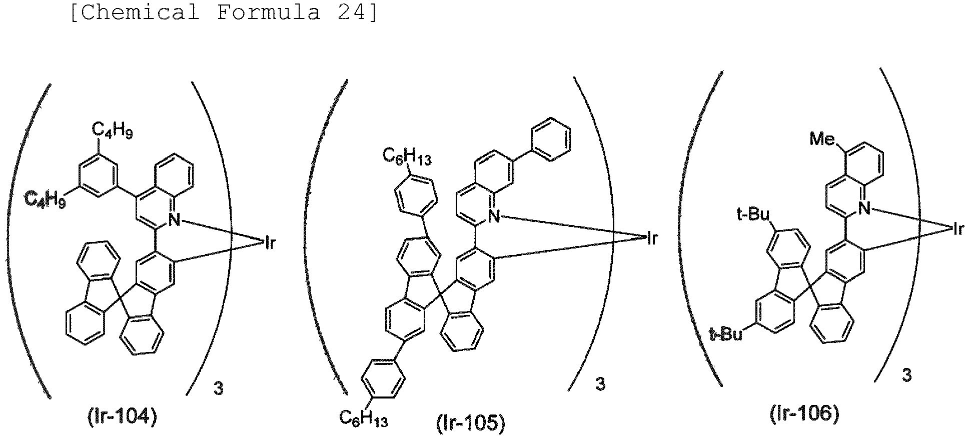

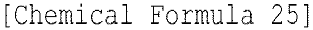

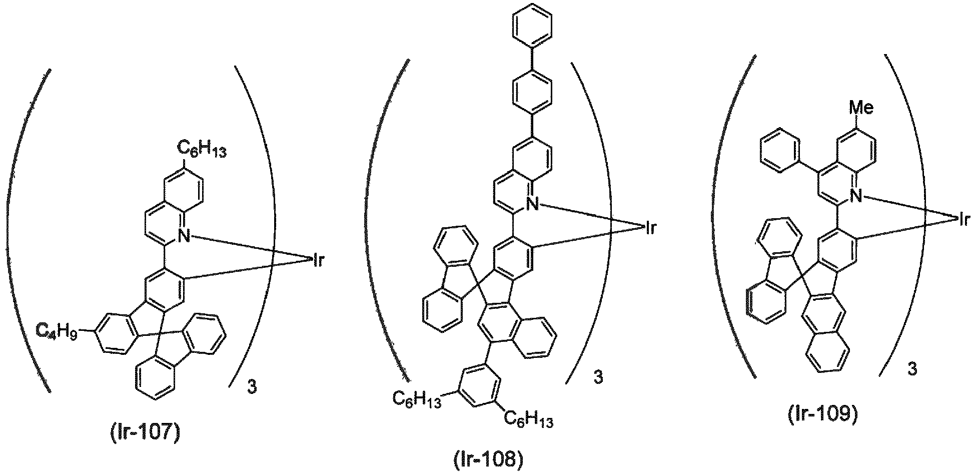

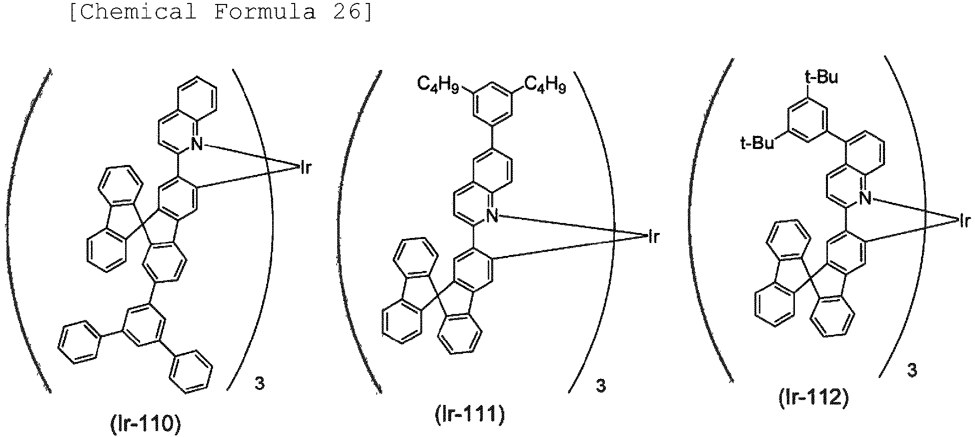

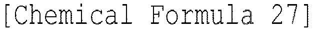

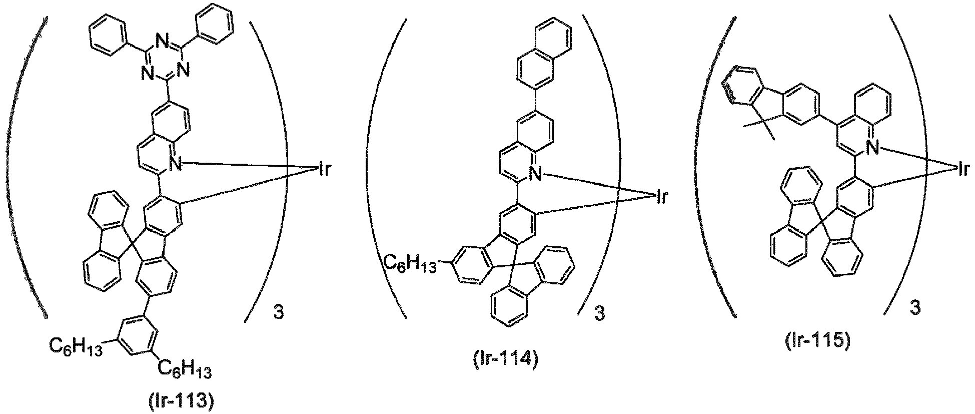

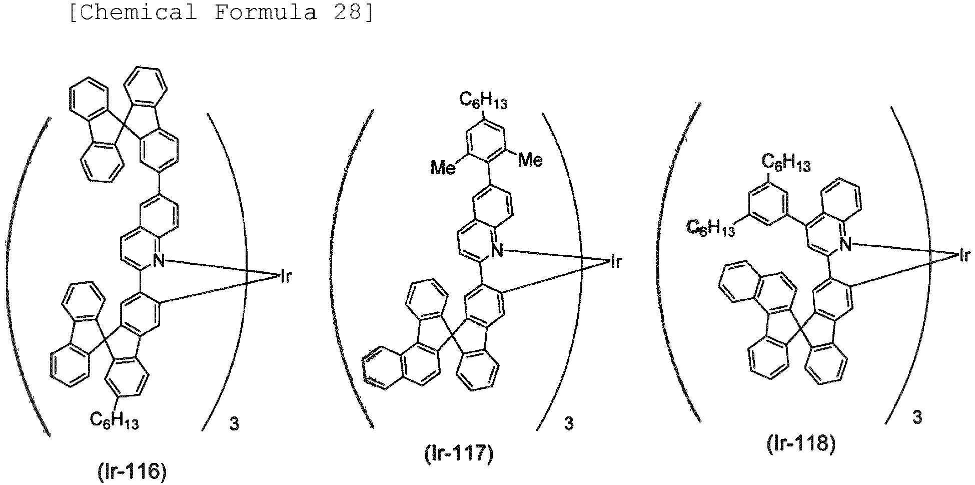

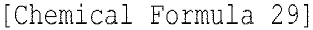

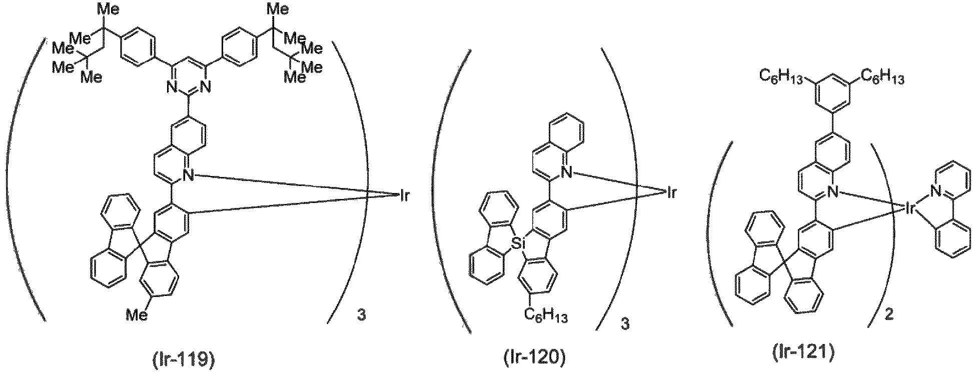

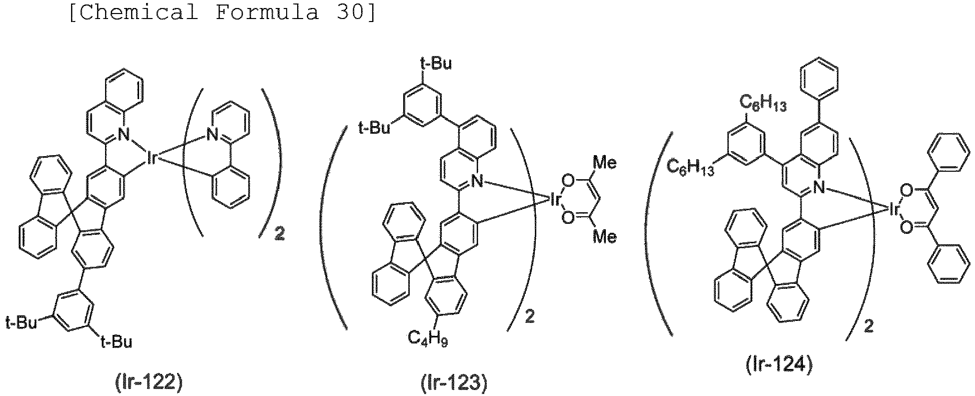

The metal complex of the present embodiment may be used singly or in combination of two or more, in the light emitting device of the present embodiment.

The metal complex of the present embodiment includes a plurality of geometric isomers envisaged, and may be any geometric isomer, and the proportion of a facial form is preferably 80% by mol or more, more preferably 90% by mol or more, further more preferably 99% by mol or more, and particularly preferably 100% by mol (namely, not containing other geometric isomers), with respect to the whole metal complex, since the half-value width in the emission spectrum of the metal complex of the present embodiment is more excellent.

### <Method for producing metal complex represented by the formula (1)>

A metal complex represented by the formula (1) as the metal complex of the present embodiment can be produced, for example, by a method of reacting a compound acting as a ligand with a metal compound. If necessary, a functional group conversion reaction of a ligand of the meta complex may be performed.

The metal complexes represented by the formula (1) in which M is an iridium atom and n1 is 2 or 3 can be produced by methods having, for example, a step A1 of reacting a compound represented by the formula (M1-1) and an iridium compound or its hydrate, to synthesize a metal complex represented by the formula (M1-2), and a step B1 of reacting the metal complex represented by the formula (M1-2), and a compound represented by the formula (M1-1) or a precursor of a ligand represented by A1-G1-A2

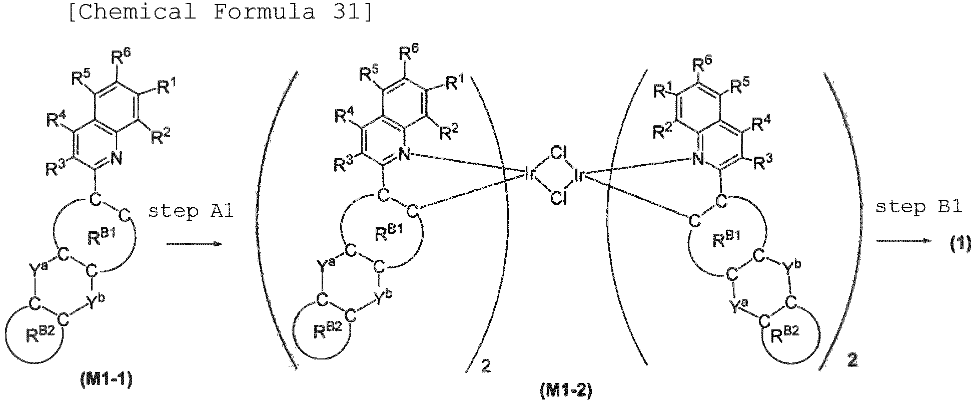

In the step A1, the iridium compound includes, for example, iridium chloride, tris(acetylacetonato)iridium (III), chloro (cyclooctadiene)iridium (I) dimer, and iridium(III) acetate, and the iridium compound hydrate includes, for example, iridium chloride•trihydrate.

The step A1 and the step B1 are conducted usually in a solvent. The solvent includes, for example, alcohol solvents such as methanol, ethanol, propanol, ethylene glycol, glycerin, 2-methoxyethanol, 2-ethoxyethanol, and the like; ether solvents such as diethyl ether, tetrahydrofuran, dioxane, cyclopentyl methyl ether, diglyme, and the like; halogen solvents such as methylene chloride, chloroform, and the like; nitrile solvents such as acetonitrile, benzonitrile, and the like; hydrocarbon solvents such as hexane, decalin, toluene, xylene, mesitylene, and the like; amide solvents such as N,N-dimethylformamide, N,N-dimethylacetamide, and the like; and, acetone, dimethyl sulfoxide, and water.

In the step A1 and the step B1, the reaction time is usually 30 minutes to 150 hours, and the reaction temperature is usually between the melting point and the boiling point of a solvent present in the reaction system.

In the step A1, the amount of a compound represented by the formula (M1-1) is usually 2 to 20 mol with respect to 1 mol of an iridium compound or its hydrate.

In the step B1, the amount of a compound represented by the formula (M1-1) or a precursor of a ligand represented by A¹-G¹-A² is usually 1 to 100 mol with respect to 1 mol of a metal complex represented by the formula (M1-2).

In the step B1, the reaction is conducted preferably in the presence of a silver compound such as silver trifluoromethanesulfonate, and the like. When a silver compound is used, its amount is usually 2 to 20 mol with respect to 1 mol of a metal complex represented by the formula (M1-2).

The metal complex represented by the formula (1) in which M is an iridium atom and n₁ is 1 can be produced, for example, by a method having a step A1' of reacting a precursor of a ligand represented by A¹-G¹-A² with an iridium compound or its hydrate, and a step B1' of reacting the metal complex obtained in the step A1' with a compound represented by the formula (M1-1).

The step A1' and the step B1' can be carried outed with reference to the step A1 and the step B1, respectively.

The compound, catalyst and solvent used in each reaction explained in <Method for producing metal complex represented by the formula (1)> may each be used singly or in combination of two or more.

### <Composition>

The composition of the present embodiment contains the metal complex of the present embodiment.

The composition of the present embodiment may be one containing at least one material selected from the group consisting of a hole transporting material, a hole injection material, an electron transporting material, an electron injection material, a light emitting material (different from the metal complex of the present embodiment), an antioxidant and a solvent, and the metal complex of the present embodiment.

Further, the composition of the present embodiment may be one containing a host material, and the metal complex of the present embodiment. That is, in the composition of the present embodiment, the metal complex of the present embodiment may be contained as a guest material against a host material.

In the composition of the present embodiment, the metal complex of the present embodiment may be contained singly or in combination of two or more.

### [Host material]

When the metal complex of the present embodiment is a composition with a host material having at least one function selected from hole injectability, hole transportability, electron injectability and electron transportability, a light emitting device obtained using the metal complex of the present embodiment is more excellent in external quantum yield. In the composition of the present embodiment, the host material may be contained singly or in combination of two or more.

In a composition containing the metal complex of the present embodiment and the host material, the content of the metal complex of the present embodiment is usually 0.01 parts by mass to 80 parts by mass, preferably 0.1 parts by mass to 60 parts by mass, more preferably 0.5 parts by mass to 40 parts by mass, and further preferably 1 part by mass to 20 parts by mass, when the sum the metal complex of the present embodiment and the host material is taken as 100 parts by mass.

It is preferable that the lowest excited triplet state (T₁) of the host material has energy level equivalent to or higher than the energy level of the lowest excited triplet state (T₁) of the metal complex of the present embodiment, since the external quantum yield of a light emitting device obtained using the composition of the present embodiment is more excellent.

The host material is preferably one having solubility in a solvent capable of dissolving the metal complex of the present embodiment, since a light emitting device obtained using the composition of the present embodiment can be fabricated by a solution applying process.

The host material is classified into a low molecular host and a polymer host.

### ● Low molecular host

The low molecular host is preferably a compound represented by the formula (H-1).

Ar^{H1} and Ar^{H2} are each preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a fluorenyl group, a spirobifluorenyl group, a pyridyl group, a pyrimidinyl group, a triazinyl group, a dibenzothienyl group, a dibenzofuryl group, a carbazolyl group or an azacarbazolyl group, and further preferably a phenyl group, a fluorenyl group, a spirobifluorenyl group, a dibenzothienyl group, a dibenzofuryl group or a carbazolyl group, and these groups optionally have a substituent.

The substituent which Ar^{H1} and Ar^{H2} optionally have is preferably a halogen atom, an alkyl group, a cycloalkyl group, an alkoxy group, a cycloalkoxy group, an aryl group, a monovalent hetero ring group or a substituted amino group, more preferably an alkyl group, a cycloalkyl group, an aryl group, a monovalent hetero ring group or a substituted amino group, and further preferably an alkyl group or a cycloalkyl group, and these groups optionally further have a substituent.

The substituent which the substituent which Ar^{H1} and Ar^{H2} optionally have optionally further has is preferably a halogen atom, an alkyl group, a cycloalkyl group, an alkoxy group, a cycloalkoxy group, an aryl group, a monovalent hetero ring group or a substituted amino group, and more preferably an alkyl group or a cycloalkyl group, and these groups optionally further have a substituent, but it is preferable that they do not further have a substituent.

n^{H1} is preferably 1. n^{H2} is preferably 0.
n^{H3} is usually an integer of 0 or more and 10 or less, preferably an integer of 0 or more and 5 or less, further preferably an integer of 1 or more and 3 or less, and particularly preferably 1.
n^{H11} is preferably an integer of 1 or more and 5 or less, more preferably an integer of 1 or more and 3 or less, and further preferably 1.
R^{H11} is preferably a hydrogen atom, an alkyl group, a cycloalkyl group, an aryl group or a monovalent hetero ring group, and more preferably a hydrogen atom, an alkyl group or a cycloalkyl group, and these groups optionally have a substituent.

The examples and preferable range of the substituent which R^{H11} optionally has are the same as the examples and preferable range of the substituent which the substituent which Ar^{H1} and Ar^{H2} optionally have optionally further has.

L^{H1} is preferably an arylene group or a divalent hetero ring group.

L^{H1} includes, for example, groups represented by the formula (A-1) to the formula (A-20) and the formula (AA-1) to the formula (AA-34), and is preferably a group represented by the formula (A-1), the formula (A-2), the formula (A-8), the formula (A-9), the formula (AA-1) to the formula (AA-4), the formula (AA-10) to the formula (AA-15) or the formula (AA-29) to the formula (AA-34), more preferably a group represented by the formula (A-1), the formula (A-2), the formula (A-8), the formula (A-9), the formula (AA-2), the formula (AA-4), the formula (AA-10) to the formula (AA-15), and further preferably a group represented by the formula (A-1), the formula (A-2), the formula (AA-2), the formula (AA-4) or the formula (AA-14).

The substituent which L^{H1} optionally has is preferably a halogen atom, an alkyl group, a cycloalkyl group, an alkoxy group, a cycloalkoxy group, an aryl group or a monovalent hetero ring group, and more preferably an alkyl group, a cycloalkyl group, an aryl group or a monovalent hetero ring group, and these groups optionally further have a substituent.

The examples and preferable range of the substituent which the substituent which L^{H1} optionally has optionally further has are the same as the examples and preferable range of the substituent which the substituent which Ar^{H1} and Ar^{H2} optionally have optionally further has.

R^{H21} is preferably an aryl group or a monovalent hetero ring group, and these groups optionally have a substituent.

The examples and the preferable ranges of the aryl group and the monovalent hetero ring group represented by R^{H21} are the same as the examples and the preferable ranges of the aryl group and the monovalent hetero ring group represented by Ar^{H1} and Ar^{H2}.

The examples and the preferable range of the substituent which R^{H21} optionally has are the same as the examples and the preferable range of the substituent which Ar^{H1} and Ar¹¹² optionally have.

The compound represented by the formula (H-1) is preferably a compound represented by the formula (H-2). 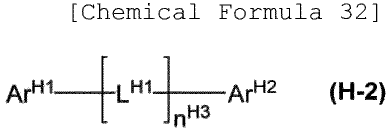 [wherein, Ar^{H1}, Ar^{H2}, n^{H3} and L^{H1} represent the same meaning as described above.]

Specific examples of the low molecular compound used for the host material include compounds represented by the following formulae.

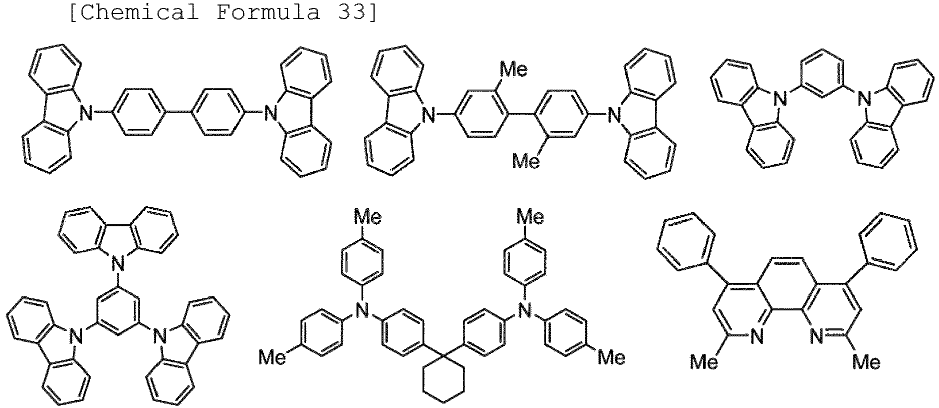

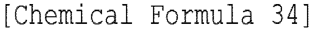

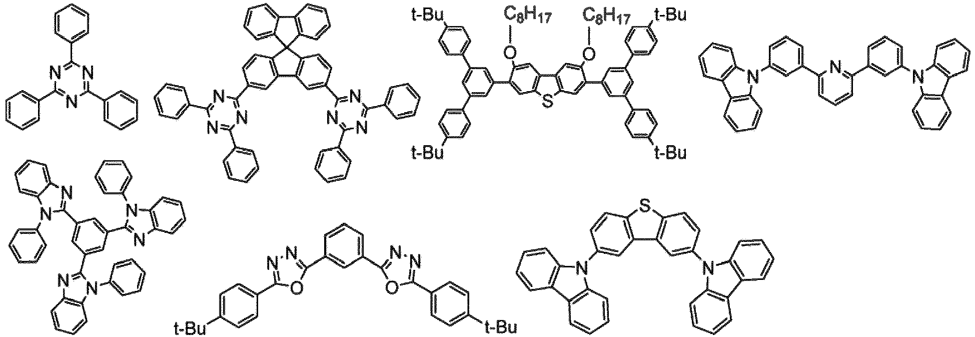

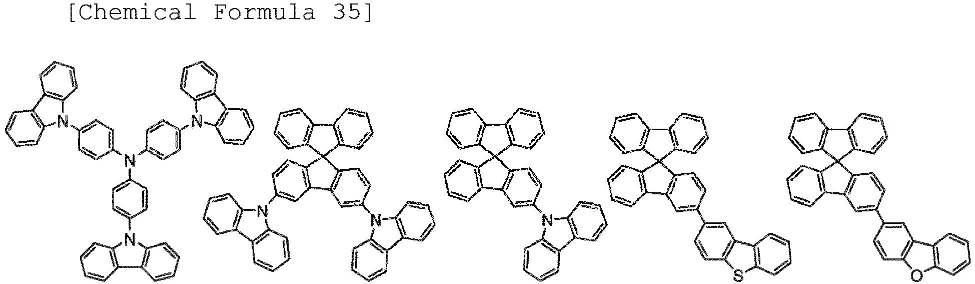

### • Polymer host

The polymer compound used for the host material includes, for example, polymer compounds as the hole transporting material described later, and polymer compounds as the electron transporting material described later.

The polymer compound which is preferable as the host material (hereinafter, referred to also as "polymer host") will be described.

The polymer host is preferably a polymer compound containing a constitutional unit represented by the formula (Y) .

The arylene group represented by Ar^{Y1} is more preferably a group represented by the formula (A-1), the formula (A-2), the formula (A-6) to the formula (A-10), the formula (A-19) or the formula (A-20), and further preferably a group represented by the formula (A-1), the formula (A-2), the formula (A-7), the formula (A-9) or the formula (A-19), and these groups optionally have a substituent.

The divalent hetero ring group represented by Ar^{Y1} is more preferably a group represented by the formula (AA-1) to the formula (AA-4), the formula (AA-10) to the formula (AA-15), the formula (AA-18) to the formula (AA-21) or the formula (AA-33), and further preferably a group represented by the formula (AA-4), the formula (AA-10), the formula (AA-12), the formula (AA-14) or the formula (AA-33), and these groups optionally have a substituent.

The more preferable ranges and further preferable ranges of the arylene group and the divalent hetero ring group for the divalent group in which an arylene group and a divalent hetero ring group are bonded directly represented by Ar^{Y1} are the same as the more preferable ranges and further preferable ranges of the arylene group and the divalent hetero ring group represented by Ar^{Y1} described above, respectively.

"The divalent group in which an arylene group and a divalent hetero ring group are bonded directly" includes, for example, groups represented by the following formulae, and these optionally have a substituent.

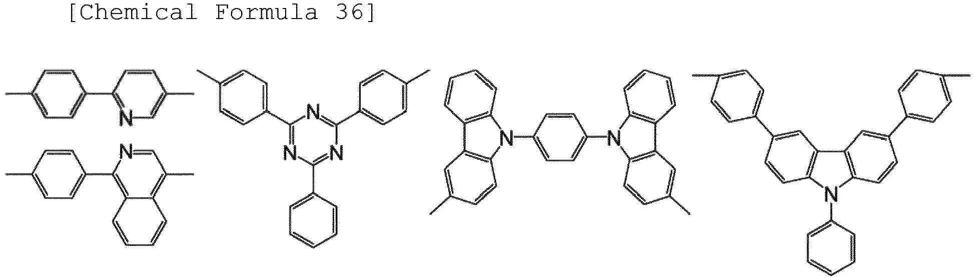

The substituent which a group represented by Ar^{Y1} optionally has is preferably an alkyl group, a cycloalkyl group, an aryl group or a monovalent hetero ring group, and more preferably an alkyl group, a cycloalkyl group or an aryl group, and these groups optionally further have a substituent.

The substituent which the substituent which a group represented by Ar^{Y1}optionally has optionally further has is preferably an alkyl group or a cycloalkyl group, and these groups optionally further have a substituent, but it is preferable that they do not further have a substituent.

The constitutional unit represented by the formula (Y) includes, for example, constitutional units represented by the formula (Y-1) to the formula (Y-10), and is preferably a constitutional unit represented by the formula (Y-1) to the formula (Y-3) from the standpoint of light emission efficiency of the light emitting device of the present embodiment, preferably a constitutional unit represented by the formula (Y-4) to the formula (Y-7) from the standpoint of electron transportability, and preferably a constitutional unit represented by the formula (Y-8) to the formula (Y-10) from the standpoint of hole transportability. 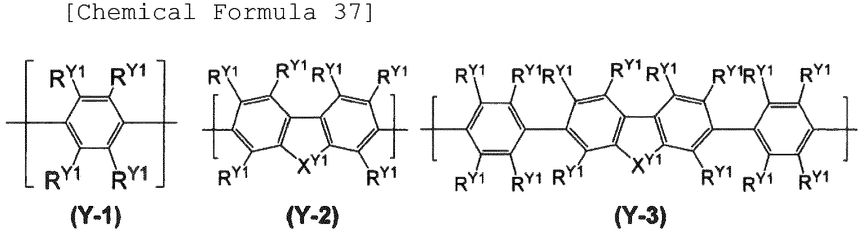 [wherein,
R^{Y1} represents a hydrogen atom, an alkyl group, a cycloalkyl group, an alkoxy group, a cycloalkoxy group, an aryl group or a monovalent hetero ring group, and these groups optionally have a substituent. A plurality of R^{Y1} may be the same or different, and adjacent groups R^{Y1} may be combined together to form a ring together with carbon atoms to which they are attached.
X^{Y1} represents a group represented by -C(R^{Y2})₂-, - C(R^{Y2})=C(R^{Y2})- or -C(R^{Y2})₂-C(R^{Y2})₂-. R^{Y2} represents a hydrogen atom, an alkyl group, a cycloalkyl group, an alkoxy group, a cycloalkoxy group, an aryl group or a monovalent hetero ring group, and these groups optionally have a substituent. A plurality of R^{Y2} may be the same or different, and groups R^{Y2} may be combined together to form a ring together with carbon atoms to which they are attached.]
R^{Y1} is preferably a hydrogen atom, an alkyl group, a cycloalkyl group or an aryl group, and these groups optionally have a substituent.
R^{Y2} is preferably an alkyl group, a cycloalkyl group, an aryl group or a monovalent hetero ring group, and more preferably an alkyl group, a cycloalkyl group or an aryl group, and these groups optionally have a substituent.

In X^{Y1}, the combination of two groups R^{Y2} in the group represented by -C(R^{Y2})₂- is preferably a combination in which both are alkyl groups or cycloalkyl groups, both are aryl groups, both are monovalent hetero ring groups, or one is an alkyl group or a cycloalkyl group and the other is an aryl group or a monovalent hetero ring group, and more preferably a combination in which one is an alkyl group or a cycloalkyl group and the other is an aryl group, and these groups optionally have a substituent. Two groups R^{Y2} may be combined together to form a ring together with atoms to which they are attached, and when R^{Y2} forms a ring, the group represented by -C(R^{Y2})₂- is preferably a group represented by the formula (Y-A1) to formula (Y-A5), and more preferably a group represented by the formula (Y-A4), and these groups optionally have a substituent.

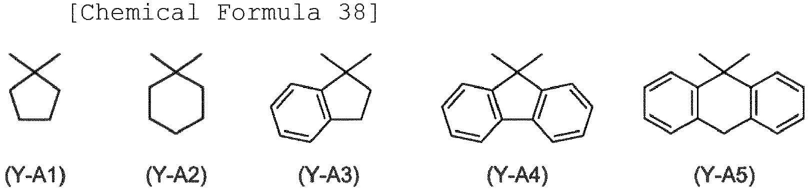

In X^{Y1}, the combination of two groups R^{Y2} in the group represented by -C(R^{Y2})=C(R^{Y2})- is preferably a combination in which both are alkyl groups or cycloalkyl groups, or one is an alkyl group or a cycloalkyl group and the other is an aryl group, and these groups optionally have a substituent.

In X^{Y1}, four groups R^{Y2} in the group represented by - C(R^{Y2})₂-C(R^{Y2})₂- are preferably alkyl groups or cycloalkyl groups optionally having a substituent. A plurality of R^{Y2} may be combined together to form a ring together with atoms to which they are attached, and when R^{Y2} forms a ring, the group represented by -C(R^{Y2})₂-C(R^{Y2})₂ - is preferably a group represented by the formula (Y-B1) to formula (Y-B5), and more preferably a group represented by the formula (Y-B3), and these groups optionally have a substituent. 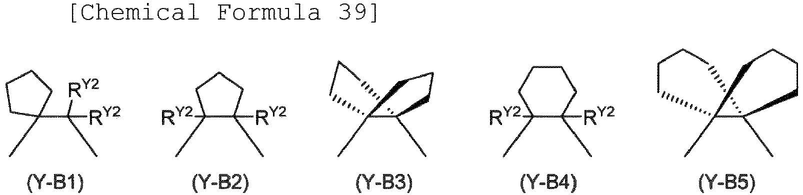 [wherein, R^{Y2} represents the same meaning as described above.]

X^{Y1} is preferably a group represented by -C(R^{Y2})₂-. 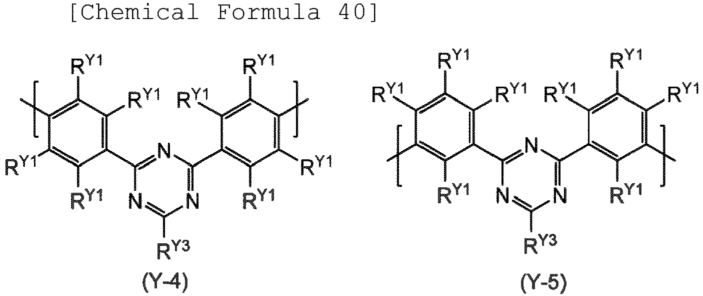 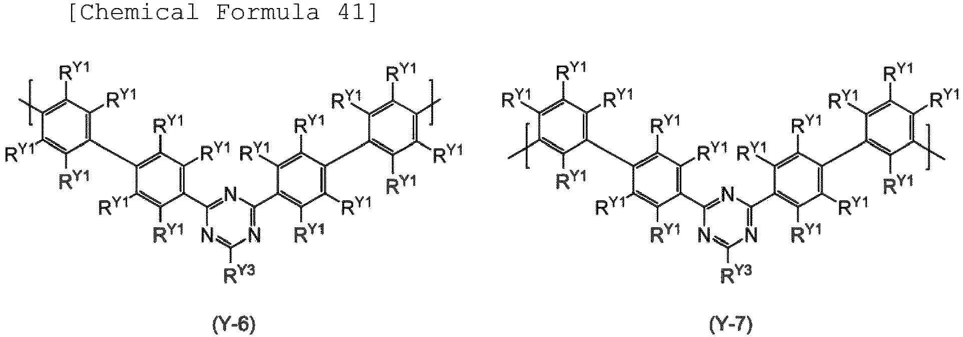 [wherein,
R^{Y1} represents the same meaning as described above.
R^{Y3} represents a hydrogen atom, an alkyl group, a cycloalkyl group, an alkoxy group, a cycloalkoxy group, an aryl group or a monovalent hetero ring group, and these groups optionally have a substituent.]
R^{Y3} is preferably an alkyl group, a cycloalkyl group, an alkoxy group, a cycloalkoxy group, an aryl group or a monovalent hetero ring group, and more preferably an aryl group, and these groups optionally have a substituent. 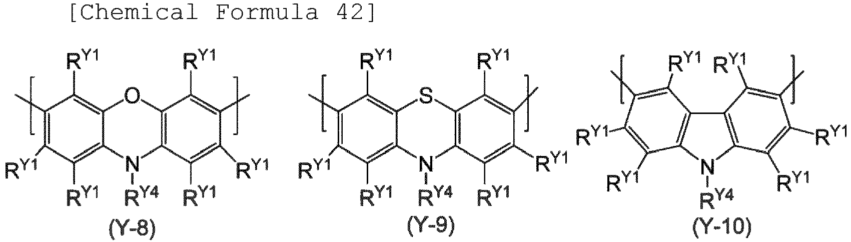 [wherein,
   R^{Y1} represents the same meaning as described above.
   R^{Y4} represents a hydrogen atom, an alkyl group, a cycloalkyl group, an alkoxy group, a cycloalkoxy group, an aryl group or a monovalent hetero ring group, and these groups optionally have a substituent.]
R^{Y4} is preferably an alkyl group, a cycloalkyl group, an alkoxy group, a cycloalkoxy group, an aryl group or a monovalent hetero ring group, and more preferably an aryl group, and these groups optionally have a substituent.

The preferable range of the substituent which a group represented by R^{Y1} to R^{Y4} and R^{Y11} optionally has are the same as the preferable range of the substituent which a group represented by Ar^{Y1} optionally has.

The constitutional unit represented by the formula (Y) includes, for example, constitutional units comprising an arylene group represented by the formula (Y-101) to the formula (Y-121), constitutional units comprising a divalent hetero ring group represented by the formula (Y-201) to the formula (Y-206), and constitutional units comprising a divalent group in which an arylene group and a divalent hetero ring group are bonded directly represented by the formula (Y-301) to the formula (Y-304).

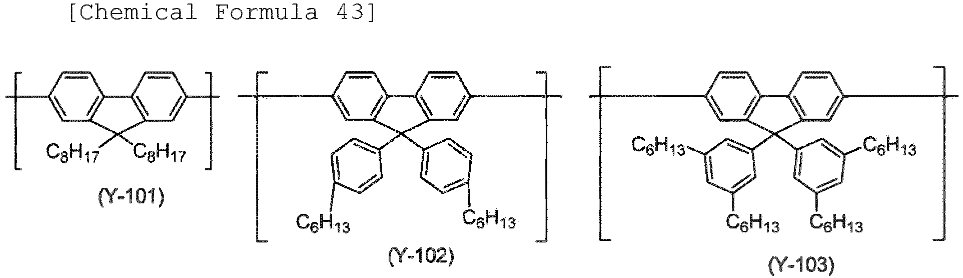

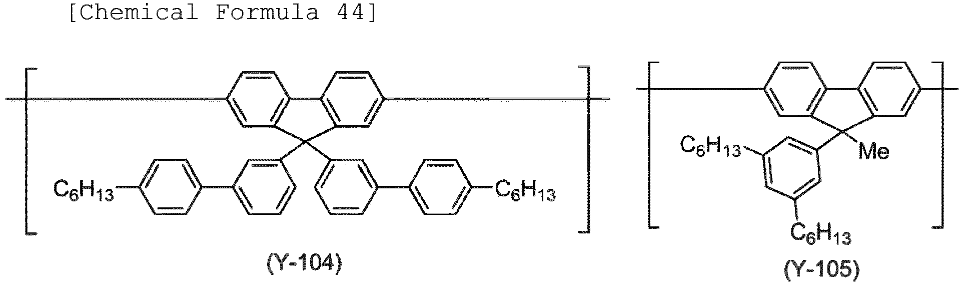

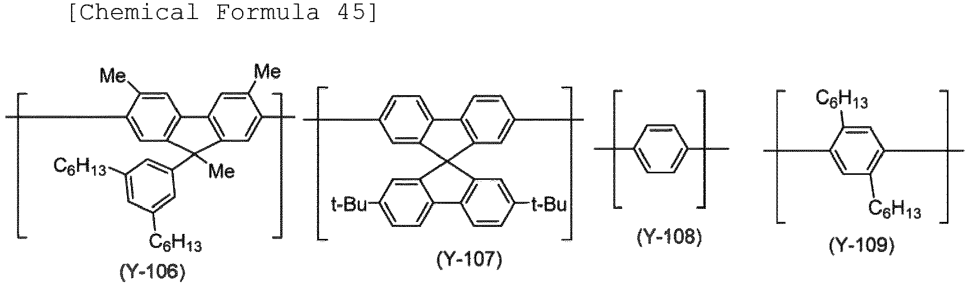

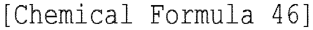

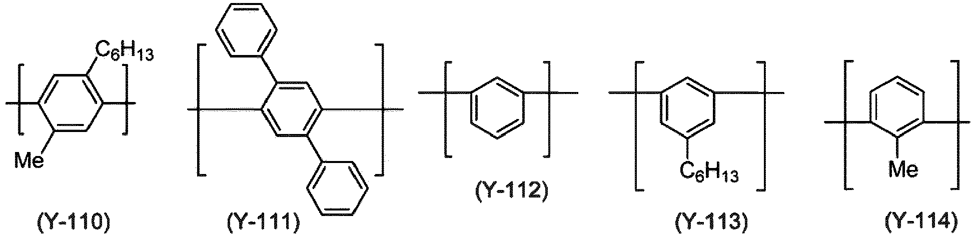

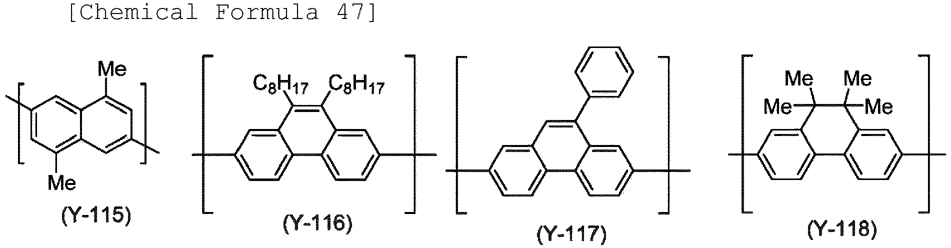

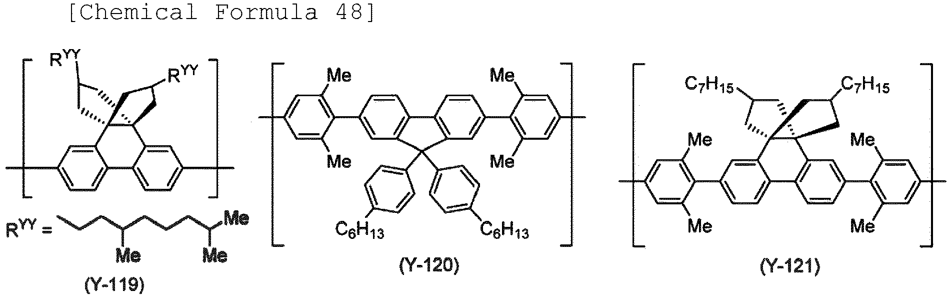

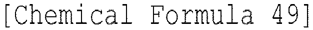

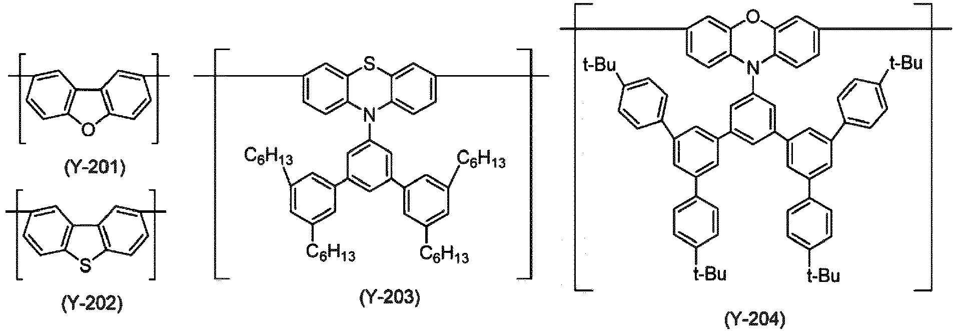

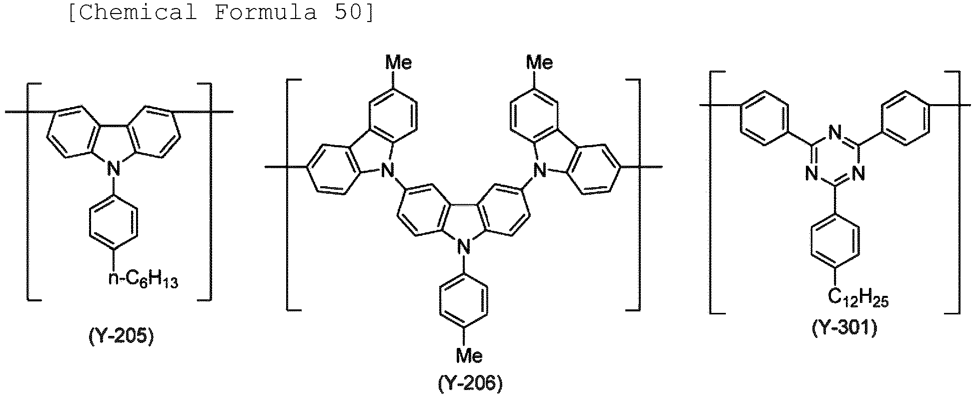

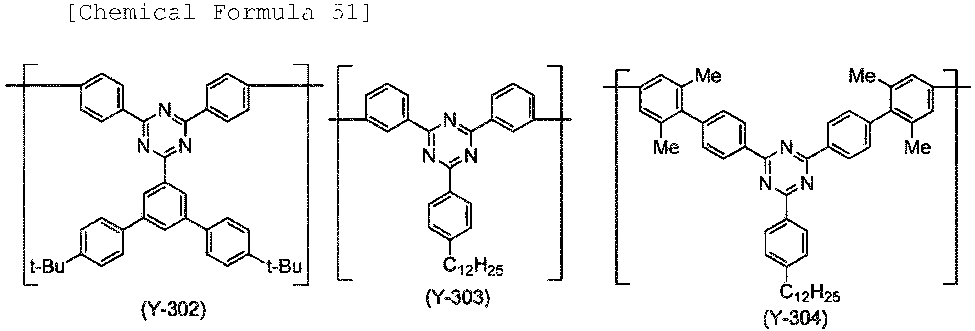

The amount of the constitutional unit represented by the formula (Y) in which Ar^{Y1} is an arylene group is preferably 0.5 to 100% by mol, and more preferably 60 to 95% by mol, with respect to the total amount of constitutional units contained in the polymer host, since the light emitting device of the present embodiment is excellent in light emission efficiency.

The amount of the constitutional unit represented by the formula (Y) in which Ar^{Y1} is a divalent hetero ring group, or a divalent group in which an arylene group and a divalent hetero ring group are bonded directly is preferably 0.5 to 30% by mol, and more preferably 3 to 20% by mol, with respect to the total amount of constitutional units contained in the polymer host, since its charge transportability is excellent.

The constitutional unit represented by the formula (Y) may be contained only singly or in combination of two or more in the polymer host.

It is preferable that the polymer host further contains a constitutional unit represented by the formula (X), since its hole transportability is excellent. 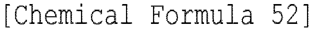 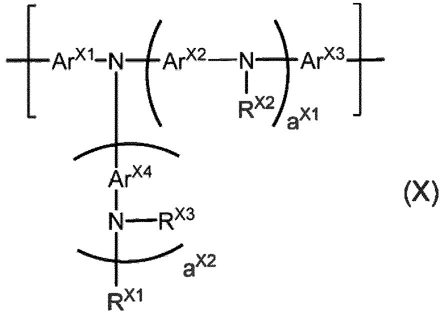 [wherein,
a^{X1} and a^{X2} each independently represent an integer of 0 or more.
Ar^{X1} and Ar^{X3} each independently represent an arylene group or a divalent hetero ring group, and these groups optionally have a substituent.
Ar^{X2} and Ar^{X4} each independently represent an arylene group, a divalent hetero ring group, or a divalent group in which an arylene group and a divalent hetero ring group are bonded directly, and these groups optionally have a substituent. When a plurality of Ar^{X2} and Ar^{X4} are present, they may be the same or different.
R^{X1}, R^{X2} and R^{X3} each independently represent a hydrogen atom, an alkyl group, a cycloalkyl group, an aryl group or a monovalent hetero ring group, and these groups optionally have a substituent. When a plurality of R^{X2} and R^{X3} are present, they may be the same or different.]

a^{X1} is usually an integer of 0 to 5, preferably an integer of 0 to 2, and more preferably 0 or 1. a^{X2} is usually an integer of 0 to 5, preferably an integer of 0 to 2, and more preferably 0.

The preferable ranges and more preferable range of R^{X1}, R^{X2} and R^{X3} are the same as the preferable range and more preferable range of R^{Y4}.

The preferable ranges and more preferable ranges of the arylene group and the divalent hetero ring group represented by Ar^{X1}, Ar^{X2}, Ar^{X3} and Ar^{X4} are the same as the preferable ranges and more preferable range of the arylene group and the divalent hetero ring group represented by Ar^{Y1}, respectively.

The examples and preferable range of the divalent group in which an arylene group and a divalent hetero ring group are bonded directly represented by Ar^{X2} and Ar^{X4} are the same as the examples and preferable range of the divalent group in which an arylene group and a divalent hetero ring group are bonded directly represented by Ar^{Y1}.

Ar^{X1}, Ar^{X2}, Ar^{X3} and Ar^{X4} are each preferably an arylene group optionally having a substituent.

The preferable range of the substituent which a group represented by Ar^{X1} to Ar^{X4} and R^{X1} to R^{X3} optionally has is the same as the preferable range of the substituent which a group represented by Ar^{Y1} optionally has.

The constitutional unit represented by the formula (X) may be contained only singly or in combination of two or more in the polymer host.

The amount of the constitutional unit represented by the formula (X) is preferably 0.1 to 50% by mol, more preferably 1 to 40% by mol, and further preferably 2 to 30% by mol, with respect to the total amount of constitutional units contained in a polymer host, since its hole transportability is excellent.

The constitutional unit represented by the formula (X) includes, for example, constitutional units represented by the formula (X1-1) to formula (X1-11).

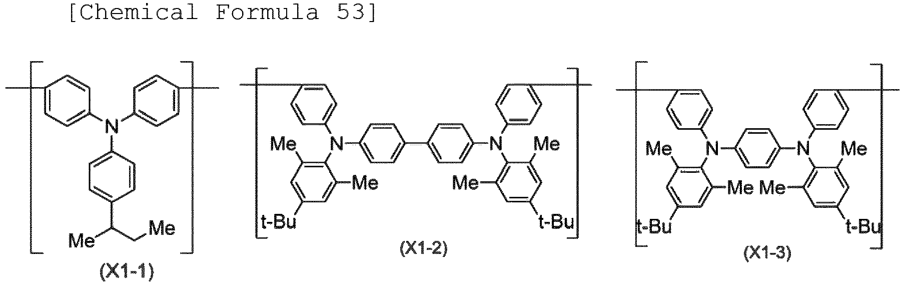

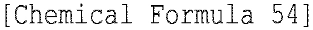

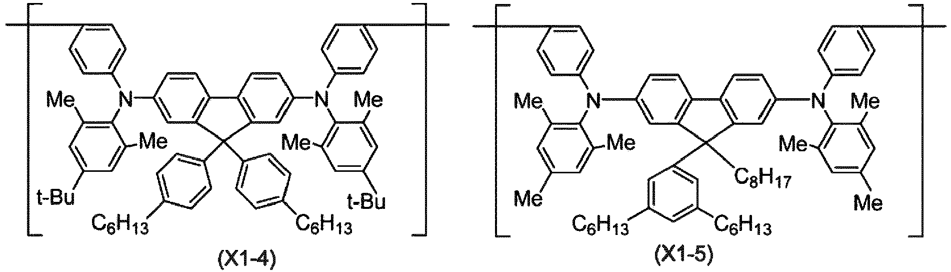

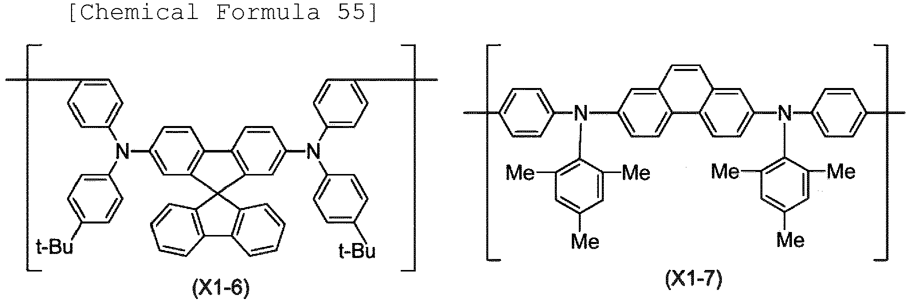

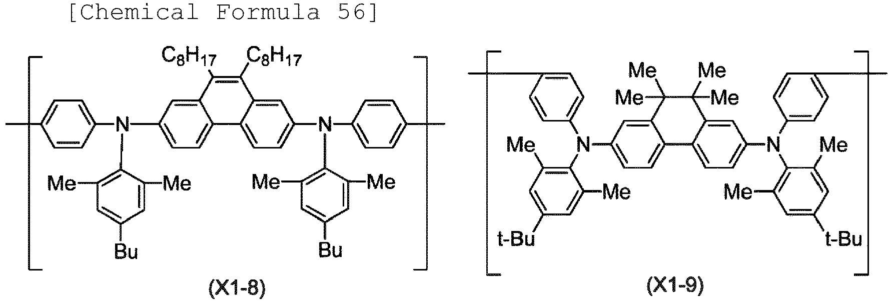

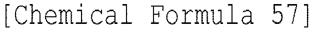

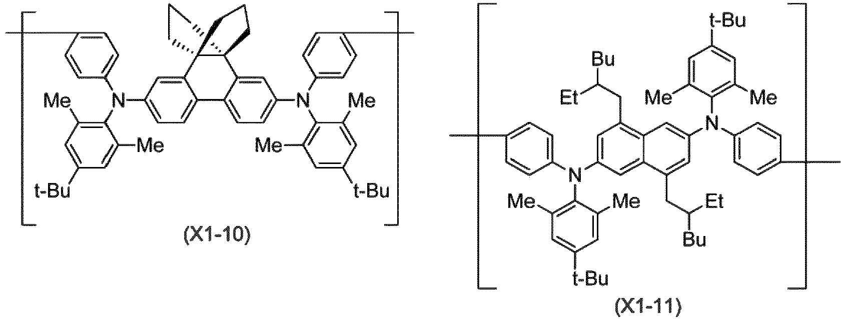

In the polymer host, the constitutional unit represented by the formula (X) may be contained only singly or in combination of two or more.

The polymer host includes, for example, polymer compounds P-1 to P-7 in Table 1. In the description, "other" constitutional unit means a constitutional unit other than the constitutional unit represented by the formula (Y) and the constitutional unit represented by the formula (X).

**[Table 1]**

| Polymer compound | Constitutional unit and molar ratio thereof | | | | |
|---|---|---|---|---|---|
| | Formula (Y) | | | Formula (X) | other |
| | Formula (Y-1) to formula (Y-3) | Formula (Y-4) to formula (Y-7) | Formula (Y-8) to formula (Y-10) | Formula (X-1) to formula (X-7) | |
| | p | q | r | s | t |
| P-1 | 0.1 to 99.9 | 0.1 to 99.9 | 0 | 0 | 0 to 30 |
| P-2 | 0.1 to 99.9 | 0 | 0.1 to 99.9 | 0 | 0 to 30 |
| P-3 | 0.1 to 99.9 | 0 | 0 | 0.1 to 99.9 | 0 to 30 |
| P-4 | 0.1 to 99.8 | 0.1 to 99.8 | 0 | 0.1 to 99.8 | 0 to 30 |
| P-5 | 0.1 to 99.8 | 0.1 to 99.8 | 0.1 to 99.8 | 0 | 0 to 30 |
| P-6 | 0.1 to 99.8 | 0 | 0.1 to 99.8 | 0.1 to 99.8 | 0 to 30 |
| P-7 | 0.1 to 99.7 | 0.1 to 99.7 | 0.1 to 99.7 | 0.1 to 99.7 | 0 to 30 |

In Table 1, p, q, r, s and t represent the molar ratio of each constitutional unit. p+q+r+s+t = 100, and 100 ≥ p+q+r+s ≥ 70. The other constitutional unit means a constitutional unit other than the constitutional unit represented by the formula (Y) and the constitutional unit represented by the formula (X).

The polymer host may be any of a block copolymer, a random copolymer, an alternative copolymer or a graft copolymer, and may also be in other form, and from the above-described standpoint, a copolymer obtained by copolymerizing multiple kinds of raw material monomers is preferred.

<Method for producing polymer host>

The polymer host can be produced using a known polymerization method described in Chemical Reviews (Chem. Rev.), vol. 109, pp. 897-1091 (2009), and the like, and exemplified are methods for polymerizing by a coupling reaction using a transition metal catalyst, such as the Suzuki reaction, the Yamamoto reaction, the Buchwald reaction, the Stille reaction, the Negishi reaction, the Kumada reaction, and the like.

In the above-described polymerization method, the method of charging monomers includes a method of charging the entire amount of monomers into the reaction system at once, a method in which a part of monomers is charged and reacted, and then the remaining monomers are charged in a batch, continuously or dividedly, a method of charging monomers continuously or dividedly, and the like.

The transition metal catalyst includes, but not limited to, a palladium catalyst and a nickel catalyst.

The post treatment of the polymerization reaction is conducted by known methods, for example, a method of removing water-soluble impurities by liquid separation, a method in which the reaction liquid after the polymerization reaction is added to a lower alcohol such as methanol and the like, the deposited precipitate is filtrated, then, dried, and other methods, singly or in combination. When the purity of the polymer host is low, it can be purified by usual methods such as, for example, recrystallization, reprecipitation, continuous extraction with Soxhlet extractor, column chromatography, and the like.

### [Hole transporting material]

The hole transporting material is classified into a low molecular compound and a polymer compound, and a polymer compound is preferable, with a polymer compound having a cross-linkable group being more preferred.

The polymer compound includes, for example, polyvinylcarbazole and derivatives thereof; and polyarylenes having an aromatic amine structure in the side chain or main chain and derivatives thereof. The polymer compound may also be a compound to which an electron accepting site is bonded. The electron accepting site includes, for example, fullerene, tetrafluorotetracyanoquinodimethane, tetracyanoethylene, trinitrofluorenone, and the like, preferably includes fullerene.

In the composition of the present embodiment, the blending amount of the hole transporting material is usually 1 part by mass to 400 parts by mass, and preferably 5 parts by mass to 150 parts by mass, with respect to 100 parts by mass of the metal complex of the present embodiment.

The hole transporting material may be used singly or in combination of two or more.

### [Electron transporting material]

The electron transporting material is classified into a low molecular compound and a polymer compound. The electron transporting material may have a cross-linkable group.

The low molecular compound includes, for example, a metal complex having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

The polymer compound includes, for example, polyphenylene, polyfluorene, and derivatives thereof. The polymer compound may be doped with a metal.

In the composition of the present embodiment, the blending amount of the electron transporting material is usually 1 part by mass to 400 parts by mass, and preferably 5 parts by mass to 150 parts by mass, with respect to 100 parts by mass of the metal complex of the present embodiment.

The electron transporting material may be used singly or in combination of two or more.

### [Hole injection material and electron injection material]

The hole injection material and the electron injection material are each classified into a low molecular compound and a polymer compound. The hole injection material and the electron injection material may have a cross-linkable group.

The low molecular compound includes, for example, metal phthalocyanines such as copper phthalocyanine, and the like; carbon; oxides of metals such as molybdenum, tungsten, and the like; metal fluorides such as lithium fluoride, sodium fluoride, cesium fluoride, potassium fluoride, and the like.

The polymer compound includes electrically conductive polymers such as, for example, polyaniline, polythiophene, polypyrrole, polyphenylenevinylene, polythienylenevinylene, polyquinoline and polyquinoxaline, and derivatives thereof; polymers having a group represented by the formula (X) in the main chain or side chain, and the like.

In the composition of the present embodiment, the blending amounts of the hole injection material and the electron injection material are usually 1 part by mass to 400 parts by mass, and preferably 5 parts by mass to 150 parts by mass, respectively, with respect to 100 parts by mass of the metal complex of the present embodiment.

The hole injection material and the electron injection material each may be used singly or in combination of two or more.

### [Ion doping]

When the hole injection material or the electron injection material contains a conductive polymer, the electric conductivity of the conductive polymer is preferably 1×10⁻⁵ S/cm to 1×10³ S/cm. In order to regulate the electric conductivity of the conductive polymer within such a range, the conductive polymer can be doped with an appropriate amount of ions.

The kind of the ion to be doped is an anion for the hole injection material, and a cation for the electron injection material. The anion includes, for example, a polystyrenesulfonate ion, an alkylbenzenesulfonate ion, and a camphorsulfonate ion. The cation includes, for example, a lithium ion, a sodium ion, a potassium ion, and a tetrabutylammonium ion.

The ion to be doped may be used only singly or in combination of two or more.

### [Light emitting material]

The light emitting material (different from the metal complex of the present embodiment) is classified into a low molecular compound and a polymer compound. The light emitting material may have a cross-linkable group.

The low molecular compound includes, for example, naphthalene and derivatives thereof, anthracene and derivatives thereof, perylene and derivatives thereof, and, triplet light emitting complexes having iridium, platinum or europium as the central metal.

The polymer compound includes polymer compounds containing, for example, a phenylene group, a naphthalenediyl group, an anthracenediyl group, a fluorenediyldiyl group, a phenanthrenediyl group, a dihydrophenanthrenediyl group, a group represented by the above-described formula (X), a carbazolediyl group, a phenoxazinediyl group, a phenothiazinediyl group, an anthracenediyl group, and/or a pyrenediyl group, and the like.

The light emitting material may contain a low molecular compound and a polymer compound, and preferably contains a triplet light emitting complex and a polymer compound.

The triplet light emitting complex includes, for example, metal complexes shown below.

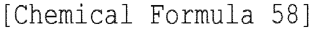

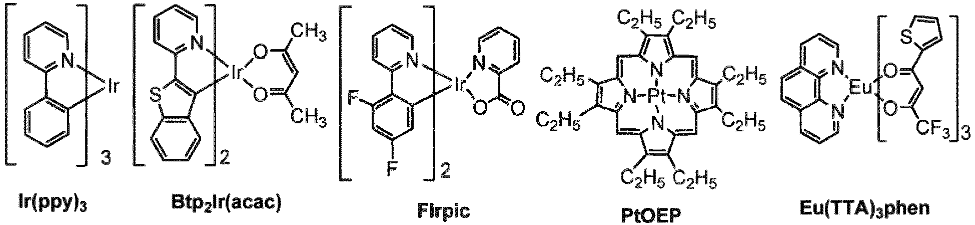

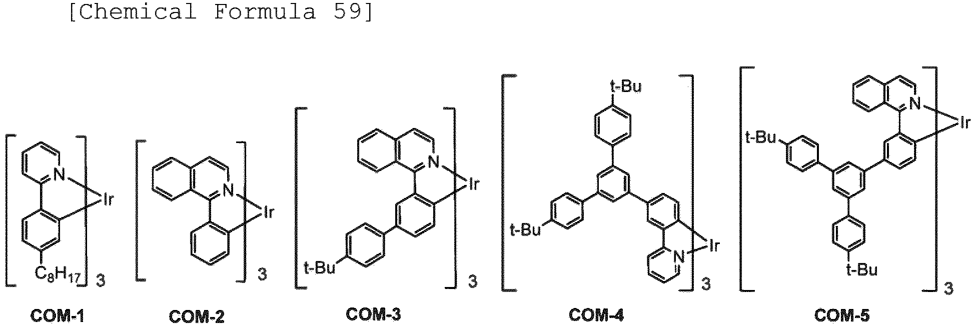

In the composition of the present embodiment, the content of the light emitting material is usually 0.1 parts by mass to 400 parts by mass, with respect to 100 parts by mass of the metal complex of the present embodiment.

A composition containing the metal complex of the present embodiment and a solvent (hereinafter, referred to as "ink" in some cases) is suitable for fabrication of a light emitting device using a printing method such as an inkjet print method, a nozzle print method, and the like.

The viscosity of the ink may be controlled depending on the type of the printing method, and when applied to printing methods in which a solution passes through a discharge device such as an inkjet print method, and the like, it is preferably 1 to 20 mPa•s at 25°C, for preventing clogging and flight bend in discharging.

The solvent contained in the ink is preferably a solvent capable of dissolving or uniformly dispersing the solid content in the ink. The solvent includes, for example, chlorine-based solvents such as 1,2-dichloroethane, 1,1,2-trichloroethane, chlorobenzene, o-dichlorobenzene, and the like; ether solvents such as tetrahydrofuran, dioxane, anisole, 4-methylanisole, and the like; aromatic hydrocarbon solvents such as toluene, xylene, mesitylene, ethylbenzene, n-hexylbenzene, cyclohexylbenzene, and the like; aliphatic hydrocarbon solvents such as cyclohexane, methylcyclohexane, n-pentane, n-hexane, n-heptane, n-octane, n-nonane, n-decane, n-decane, bicyclohexyl, and the like; ketone solvents such as acetone, methyl ethyl ketone, cyclohexanone, acetophenone, and the like; ester solvents such as ethyl acetate, butyl acetate, ethylcellosolve acetate, methyl benzoate, phenyl acetate, and the like; polyhydric alcohol solvents such as ethylene glycol, glycerin, 1,2-hexanediol, and the like; alcohol solvents such as isopropyl alcohol, cyclohexanol, and the like; sulfoxide solvents such as dimethyl sulfoxide, and the like; and, amide solvents such as N-methyl-2-pyrrolidone, N,N-dimethylformamide, and the like. The solvent may be used singly or in combination of two or more.

In the ink, the blending amount of the solvent is usually 1000 parts by mass to 100000 parts by mass, and preferably 2000 parts by mass to 20000 parts by mass, with respect to 100 parts by mass the metal complex of the present embodiment.

### <Film>

The film contains the metal complex of the present embodiment. The film may also be one containing the composition of the present embodiment.

The film is suitable as the light emitting layer in a light emitting device.

The film can be fabricated by, for example, a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method, or a nozzle coat method, using an ink.

The thickness of the film is usually 1 nm to 10 µm.

### <Light emitting device>

The light emitting device of the present embodiment is a light emitting device containing the metal complex of the present embodiment.

The constitution of the light emitting device of the present embodiment has, for example, electrodes consisting of an anode and a cathode, and a layer containing the metal complex of the present embodiment disposed between the electrodes. The layer containing the metal complex of the present embodiment may also be a layer containing the composition of the present embodiment.

### [Layer constitution]

The layer obtained using the metal complex of the present embodiment is usually at least one layer selected from the group consisting of a light emitting layer, a hole transporting layer, a hole injection layer, an electron transporting layer and an electron injection layer, with a light emitting layer being preferred. These layers contain a light emitting material, a hole transporting material, a hole injection material, an electron transporting material, and an electron injection material, respectively. Each of these layers can be formed by dissolving a light emitting material, a hole transporting material, a hole injection material, an electron transporting material, or an electron injection material in the solvent described above to prepare an ink, and using the same method as for fabrication of the film described above using the prepared ink.

The light emitting device has a light emitting layer between an anode and a cathode. The light emitting device of the present embodiment preferably has at least one of a hole injection layer and a hole transporting layer between an anode and a light emitting layer, from the standpoint of hole injectability and hole transportability, and preferably has at least one of an electron injection layer and an electron transporting layer between a cathode and a light emitting layer, from the standpoint of electron injectability and electron transportability.

The materials of the hole transporting layer, the electron transporting layer, the light emitting layer, the hole injection layer and the electron injection layer include the hole transporting material, the electron transporting material, the light emitting material, the hole injection material and the electron injection material described above, respectively, in addition to the metal complex of the present embodiment.

When the material of a hole transporting layer, the material of an electron transporting layer and the material of a light emitting layer are soluble in solvents used in forming layers adjacent to the hole transporting layer, the electron transporting layer and the light emitting layer, respectively, in fabrication of a light emitting layer, it is preferable that the materials have a cross-linkable group for avoiding dissolution of the materials in the solvents. By crosslinking the cross-linkable group after forming each layer using the material having the cross-linkable group, the layer can be insolubilized.

The method of forming each of a light emitting layer, a hole transporting layer, an electron transporting layer, a hole injection layer, an electron injection layer and the like in the light emitting device of the present embodiment includes, for example, a vacuum vapor deposition method from a powder and a method by film formation from a solution or melted state when a low molecular compound is used, and, for example, a method by film formation from a solution or melted state when a polymer compound is used.

The order, number and thickness of layers to be laminated may be adjusted in consideration of external quantum yield and device life.

### [Substrate/electrode]

The substrate in the light emitting device may advantageously be a substrate on which an electrode can be formed and which does not change chemically in forming an organic layer, and is, for example, a substrate made of a material such as glass, plastic, silicon and the like. In the case of an opaque substrate, it is preferable that the electrode farthest from the substrate is transparent or semi-transparent.

The material of the anode includes, for example, electrically conductive metal oxides and semi-transparent metals, and includes preferably indium oxide, zinc oxide, tin oxide; electrically conductive compounds such as indium•tin•oxide (ITO), indium•zinc•oxide, and the like; argentine-palladium-copper (APC) composite; NESA, gold, platinum, silver, and copper.

The material of the cathode includes, for example, metals such as lithium, sodium, potassium, rubidium, cesium, beryllium, magnesium, calcium, strontium, barium, aluminum, zinc, indium, and the like; alloys composed of two or more of them; alloys composed of one or more of them and one or more of silver, copper, manganese, titanium, cobalt, nickel, tungsten, and tin; and, graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

The anode and the cathode each may take a laminated structure composed of two or more layers.

### [Application]

The light emitting device of the present embodiment is suitable, for example, for display and illumination.

Suitable embodiments of the present invention have been described above, but the present invention is not limited to the above embodiments.

### EXAMPLES

The present invention will be illustrated further in detail by examples below, but the present invention is not limited to these example.

LC-MS was measured by the following method.

The measurement sample was dissolved in chloroform or tetrahydrofuran so as to give a concentration of about 2 mg/mL, and about 1 µL of the solution was injected into LC-MS (manufactured by Agilent, trade name: 1290 Infinity LC and 6230 TOF LC/MS). As the mobile phase for LC-MS, acetonitrile and tetrahydrofuran were used and allowed to flow at a flow rate of 1.0 mL/min while changing the ratio thereof. As the column, SUMIPAX ODS Z-CLUE (manufactured by Sumika Chemical Analysis Service, Ltd., internal diameter: 4.6 mm, length: 250 mm, particle size: 3 um) was used.

NMR was measured by the following method.

A certain amount (5 to 10 mg) of the measurement sample was dissolved in about 0.5 mL of heavy chloroform (CDCl₃), heavy tetrahydrofuran, heavy dimethyl sulfoxide, heavy acetone, heavy N,N-dimethylformamide, heavy toluene, heavy methanol, heavy ethanol, heavy 2-propanol or heavy methylene chloride, and its NMR was measured using an NMR apparatus (trade name: JNM-ECZ400S/L1 manufactured by JEOL RESONANCE, or trade name: AVANCE600 manufactured by Bruker).

As an indicator for the purity of a compound, the value of high performance liquid chromatography (HPLC) area percentage was used. This value is a value at UV = 254 nm in HPLC (manufactured by Shimadzu Corp., trade name: LC-20A), unless otherwise stated. In this procedure, the compound to be measured was dissolved in tetrahydrofuran or chloroform so as to give a concentration of 0.01 to 0.2% by mass, and the solution was injected into HPLC in an amount of 1 to 10 µL depending on the concentration. As the mobile phase for HPLC, acetonitrile/tetrahydrofuran were used and allowed to flow at a flow rate of 1.0 mL/min while changing the ratio thereof from 100/0 to 0/100 (volume ratio). As the column, SUMIPAX ODS Z-CLUE (manufactured by Sumika Chemical Analysis Service, Ltd., internal diameter: 4.6 mm, length: 250 mm, particle size: 3 µm) or an ODS column having the equivalent performance was used. As the detector, Photo Diode Array Detector (manufactured by Shimadzu Corp., trade name: SPD-M20A) was used.

As an indicator for the purity of a compound, the value of gas chromatography (GC) area percentage was used. This value is a value in GC (manufactured by Agilent, trade name: Agilent7820), unless otherwise stated. In this procedure, the compound to be measured was dissolved in tetrahydrofuran or chloroform so as to give a concentration of 0.01 to 0.2% by mass, and the solution was injected into GC in an amount of 1 to 10 µL depending on the concentration. As the carrier, helium was used and allowed to flow at a flow rate of 1.0 mL/min. The column oven was used while changing the temperature from 50°C to 300°C. The heater temperature was 280°C at the injection port and 320°C at the detector. As the column, BPX-5 manufactured by SGE (30 m × 0.25 mm × 0.25 um) was used.

TLC-MS was measured by the following method.

The measurement sample was dissolved in any of toluene, tetrahydrofuran or chloroform at an arbitrary concentration, and the solution was applied on TLC plate for DART (manufactured by Techno Applications, K.K., trade name: YSK5-100), and TLC-MS was measured using a TLC-MS apparatus (manufactured by JEOL Ltd., trade name: JMS-T100TD (The AccuTOF TLC)). During measurement, the helium gas temperature was controlled in the range of 200 to 400°C.

### <Example 1> Synthesis of metal complex M1

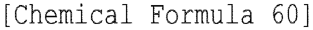

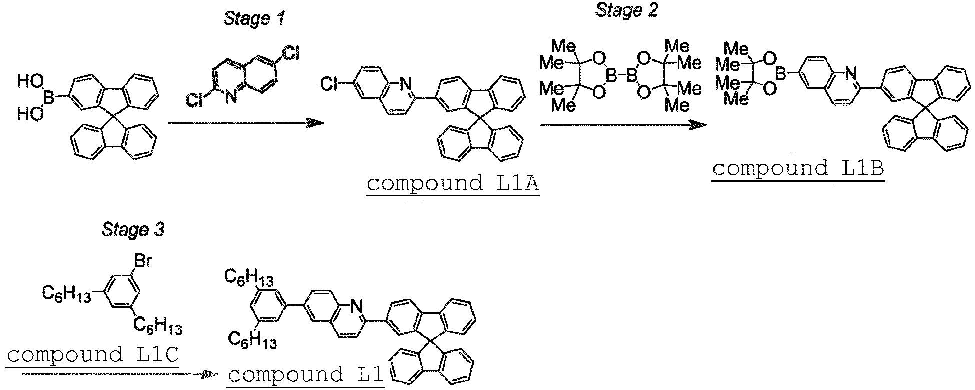

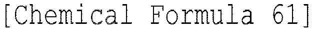

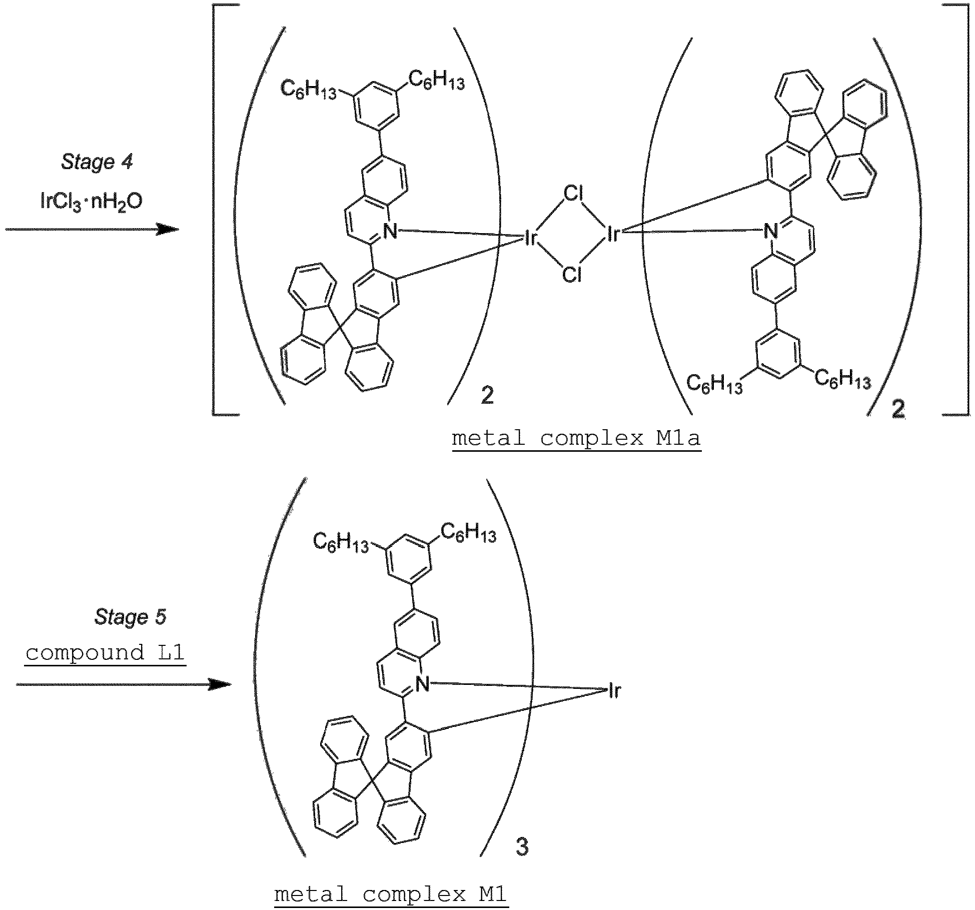

### (Stage 1: Synthesis of compound L1A)

A nitrogen atmosphere was made in a reaction vessel, then, 9,9'-spirobi[9H-fluorene]-2-boronic acid (8 g), 2,6-dichloroquinoline (4.8 g), tetrakis(triphenylphosphine)palladium(0) (0.26 g), a 20% by mass tetraethyl ammonium hydroxide aqueous solution (65.4 g) and toluene (160 mL) were added, and the mixture was stirred at 80°C for 2 hours. The resultant reaction liquid was cooled down to room temperature, then, ion exchanged water (40 mL) was added, and an aqueous layer was removed. The resultant organic layer was washed with ion exchanged water, then, dried over anhydrous magnesium sulfate, filtrated, and the resultant filtrate was concentrated under reduced pressure, to obtain a coarse product. The resultant coarse product was crystallized using a mixed solvent of toluene and ethanol, then, dried under reduced pressure, to obtain a compound L1A (10 g). The compound L1A showed an HPLC area percentage value of 99.6%.

¹H-NMR (400 MHz, CD₂Cl₂) δ: 8.18 (d, 1H), 7.99 (d, 2H), 7.95-7.89 (m, 4H), 7.78-7.71 (m, 2H), 7.54 (d, 1H), 7.51 (s, 1H), 7.43-7.37 (m, 3H), 7.25-7.08 (m, 3H), 6.72 (d, 2H), 6.67 (d, 1H).

### (Stage 2: Synthesis of compound L1B)

A nitrogen atmosphere was made in a reaction vessel, then, the compound L1A (10 g), bis(pinacolato)diboron (6.4 g), potassium acetate (3.7 g), tris(dibenzylideneacetone)dipalladium(0) (0.21 g), 2-dicyclohexylphosphino-2',4',6'-triisopropylbiphenyl (0.37 g) and 1,2-dimethoxyethane (210 mL) were added, and the mixture was stirred with heating for 1 hour. Thereafter, toluene (210 ml) was added, and the mixture was filtrated through a filter paved with Celite, and the resultant filtrate was concentrated under reduced pressure. Thereafter, toluene, n-heptane and activated carbon were added, and the mixture was stirred at room temperature for 30 minutes, then, filtrated through a filter paved with Celite, the resultant filtrate was concentrated under reduced pressure, and further crystallized using a mixed solvent of toluene/acetonitrile, to obtain a compound L1B (6.2 g) as a white solid. The compound L1B showed an HPLC area percentage value of 99.5% or more.

¹H-NMR (400 MHz, CD₂Cl₂) δ: 8.26 (dd, 2H), 8.16 (d, 1H), 8.04 (d, 1H), 7.95 (dd, 5H), 7.77 (d, 1H), 7.57 (d, 1H), 7.42 (tt, 3H), 7.13-7.18 (m, 3H), 6.76-6.78 (m, 2H), 6.71-6.73 (m, 1H), 1.36 (s, 12H).

### (Stage 3: Synthesis of compound L1)

A compound L1C was synthesized with reference to a method described in JP-A No. 2011-174062. A nitrogen atmosphere was made in a reaction vessel, then, the compound L1B (6.2 g), the compound L1C(3.9 g), tris(dibenzylideneacetone)dipalladium(0) (0.061 g), 2-dicyclohexylphosphino-2',6'-dimethoxybiphenyl (0.092 g), toluene (185 ml), a 40% by mass tetrabutyl ammonium hydroxide aqueous solution (14 g) and ion exchanged water (56 mL) were added, and the mixture was stirred with heating for 1 hour. The resultant reaction liquid was cooled down to room temperature, then, ion exchanged water (40 mL) was added, and an aqueous layer was removed. The resultant organic layer was washed with ion exchanged water, then, dried over anhydrous magnesium sulfate, filtrated, and the resultant filtrate was concentrated under reduced pressure. Toluene and activated carbon were added, and the mixture was stirred at room temperature for 30 minutes, then, filtrated through a filter paved with Celite, and the resultant filtrate was concentrated under reduced pressure. It was purified by silica gel column chromatography (a mixed solvent of toluene and n-hexane), concentrated under reduced pressure, then, further crystallized using a mixed solvent of toluene/ethanol, to obtain a compound L1 (5.8 g) as a white solid. The compound L1 showed an HPLC area percentage value of 99.5% or more.

¹H-NMR (400 MHz, CD₂Cl₂) δ: 8.29 (dd, 1H), 8.20 (d, 1H), 8.08 (d, 2H), 7.96-8.00 (m, 5H), 7.82 (d, 1H), 7.61 (d, J = 1.4 Hz, 1H), 7.46 (td, 3H), 7.38 (d, 2H), 7.19 (tq, 3H), 7.07 (s, 1H), 6.81 (dd, J = 6.4, 0.9 Hz, 2H), 6.74-6.76 (m, 1H), 2.69 (t, J = 7.8 Hz, 4H), 1.66-1.73 (m, 4H), 1.31-1.44 (m, 12H), 0.88-0.96 (m, 6H).

### (Stage 4: Synthesis of metal complex M1a)

An argon gas atmosphere was made in a light-shielded reaction vessel, then, iridium(III) chloride hydrate (0.3 g), the compound L1 (1.34 g) and 2-ethoxyethanol (9 mL) were added, and the mixture was stirred at 105°C for 1 hour. Thereafter, it was stirred at 125°C for 20 hours.

The resultant reaction mixture was cooled down to room temperature, then, added into methanol (9 mL), and the mixture was stirred at room temperature for 1 hour. Thereafter, filtration was performed, and the resultant residue was dried under reduced pressure, to obtain a red solid containing a metal complex M1a (1.15 g).

### (Stage 5: Synthesis of metal complex M1)

An argon gas atmosphere was made in a light-shielded reaction vessel, then, the red solid containing the metal complex M1a (1.10 g), the compound L1 (491 mg), silver(I) trifluoromethanesulfonate (236 mg), 2,6-lutidine (0.107 mL) and diethylene glycol dimethyl ether (6.4 mL) were added, and the mixture was stirred at 140°C for 30 hours.

The resultant reaction mixture was cooled down to room temperature, then, added into methanol (28 mL), and the mixture was stirred at room temperature for 1 hour. Thereafter, filtration was performed, toluene (20 mL) was added to the resultant residue, activated carbon was added and the mixture was stirred for 30 minutes, then, filtrated through a filter paved with Celite, and the resultant filtrate was concentrated under reduced pressure, to obtain a solid.

The resultant solid was purified sequentially by silica gel column chromatography (toluene/hexane) and crystallization (ethyl acetate, n-hexane), then, dried under reduced pressure, to obtain a metal complex M1 (500 mg, yield: 33% with respect to the charged amount of IrCl₃•3H₂O which is trihydrate of iridium(III) chloride) as a red solid. The metal complex M1 showed an HPLC area percentage value of 98.5% or more.

LC-MS (APCI, positive): m/z = 2253.1 [M+H]⁺

### <Example 2> Synthesis of metal complex M2

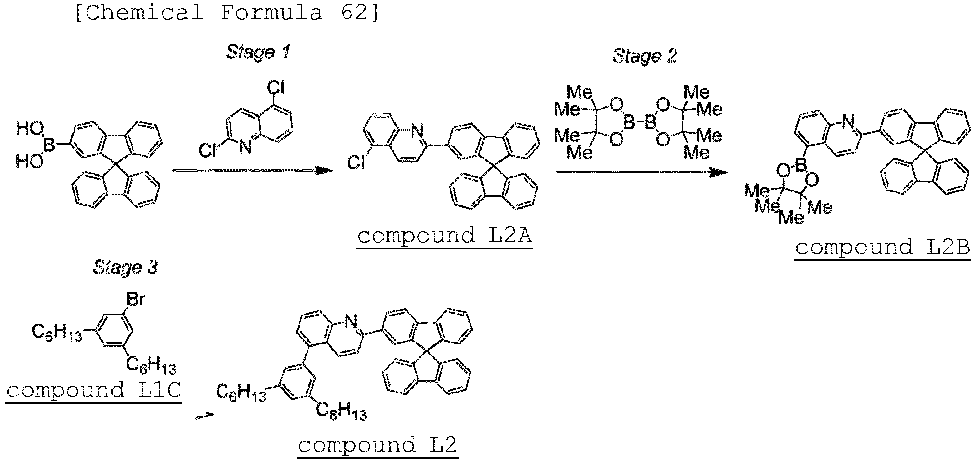

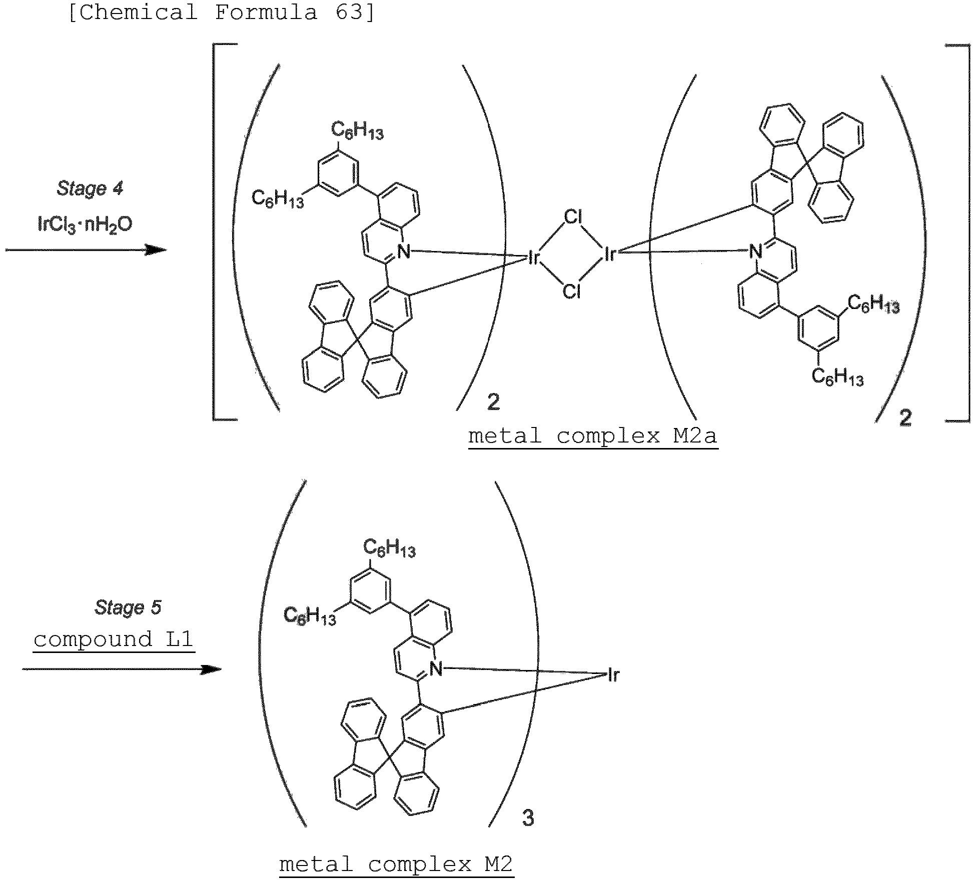

### (Stage 1: Synthesis of compound L2A)

A nitrogen atmosphere was made in a reaction vessel, then, 9,9'-spirobi[9H-fluorene]-2-boronic acid (6.0 g), 2,5-dichloroquinoline (3.6 g), tetrakis(triphenylphosphine)palladium(0) (0.96 g), a 20% by mass tetraethyl ammonium hydroxide aqueous solution (49 g) and toluene (120 mL) were added, and the mixture was stirred at 80°C for 2 hours. The resultant reaction liquid was cooled down to room temperature, then, ion exchanged water (30 mL) was added, and an aqueous layer was removed. The resultant organic layer was washed with ion exchanged water, then, dried over anhydrous magnesium sulfate, filtrated, and the resultant filtrate was concentrated under reduced pressure, to obtain a coarse product. Toluene and activated carbon were added, and the mixture was stirred at room temperature for 30 minutes, then, filtrated through a filter paved with Celite, and the resultant filtrate was concentrated under reduced pressure. Thereafter, it was crystallized using a mixed solvent of toluene and ethanol, then, dried under reduced pressure, to obtain a compound L2A (6.72 g). The compound L2A showed an HPLC area percentage value of 99.6%.

¹H-NMR (400 MHz, CD₂Cl₂) δ: 8.51 (dd, J = 9.1, 0.9 Hz, 1H), 8.28 (dd, J = 7.8, 1.8 Hz, 1H), 8.06 (d, J = 8.7 Hz, 1H), 7.95-7.99 (m, 4H), 7.88 (d, J = 8.7 Hz, 1H), 7.54-7.61 (m, 3H), 7.44 (tt, J = 7.5, 1.4 Hz, 3H), 7.14-7.20 (m, 3H), 6.78-6.80 (m, 2H), 6.72-6.74 (m, 1H).

### (Stage 2: Synthesis of compound L2B)

A nitrogen atmosphere was made in a reaction vessel, then, the compound L2A (6.6 g), bis(pinacolato)diboron (4.2 g), potassium acetate (2.7 g), tris(dibenzylideneacetone)dipalladium(0) (0.31 g), 2-dicyclohexylphosphino-2', 4',6'-triisopropylbiphenyl (0.54 g) and 1,2-dimethoxyethane (132 mL) were added, and the mixture was stirred with heating for 8 hours.

Thereafter, toluene (210 ml) was added, and the mixture was filtrated through a filter paved with Celite, and the resultant filtrate was concentrated under reduced pressure. Thereafter, toluene, n-heptane and activated carbon were added, and the mixture was stirred at room temperature for 30 minutes, then, filtrated through a filter paved with Celite, the resultant filtrate was concentrated under reduced pressure, and further crystallized using a mixed solvent of toluene/acetonitrile, to obtain a compound L2B (6.76 g) as a white solid. The compound L2B showed an HPLC area percentage value of 90% or more.

¹H-NMR (400 MHz, CD₂Cl₂) δ: 9.05 (d, 1H), 8.24 (ddd, 1H), 7.98-8.10 (m, 3H), 7.94 (t, 3H), 7.78-7.83 (m, 1H), 7.64 (dd, 1H), 7.57 (d, 1H), 7.42 (t, 3H), 7.15 (tdd, 3H), 6.77 (d, 2H), 6.72 (t, 1H), 1.39 (t, 12H).

### (Stage 3: Synthesis of compound L2)

A nitrogen atmosphere was made in a reaction vessel, then, the compound L2B (6.6 g), the compound L1C(3.8 g), tris(dibenzylideneacetone)dipalladium(0) (0.059 g), 2-dicyclohexylphosphino-2',6'-dimethoxybiphenyl (0.088 g), toluene (198 ml), a 40% by mass tetrabutyl ammonium hydroxide aqueous solution (13.6 g) and ion exchanged water (55 mL) were added, and the mixture was stirred with heating for 2 hours. The resultant reaction liquid was cooled down to room temperature, then, ion exchanged water (40 mL) was added, and an aqueous layer was removed. The resultant organic layer was washed with ion exchanged water, then, dried over anhydrous magnesium sulfate, filtrated, and the resultant filtrate was concentrated under reduced pressure. Toluene and activated carbon were added, and the mixture was stirred at room temperature for 30 minutes, then, filtrated through a filter paved with Celite, and the resultant filtrate was concentrated under reduced pressure. It was purified by silica gel column chromatography (a mixed solvent of toluene and n-hexane), concentrated under reduced pressure, then, further crystallized using acetonitrile, to obtain a compound L2 (6.22 g) as a white solid. The compound L2 showed an HPLC area percentage value of 99.5% or more.

¹H-NMR (400 MHz, CD₂Cl₂) δ: 8.18-8.24 (m, 2H), 7.90-8.02 (m, 5H), 7.65-7.69 (m, 2H), 7.54 (s, 1H), 7.37-7.41 (m, 4H), 7.04-7.14 (m, 6H), 6.75 (d, 2H), 6.69 (d, 1H), 2.16 (t, 4H), 1.66-1.73 (m, 4H), 1.31-1.44 (m, 12H), 0.88-0.96 (m, 6H).

### (Stage 4: Synthesis of metal complex M2a)

An argon gas atmosphere was made in a light-shielded reaction vessel, then, iridium(III) chloridehydrate (0.4 g), the compound L2 (1.79 g) and 2-ethoxyethanol (12 mL) were added, and the mixture was stirred at 105°C for 1 hour. Thereafter, it was stirred at 125°C for 22 hours.

The resultant reaction mixture was cooled down to room temperature, then, added into methanol (12 mL), and the mixture was stirred at room temperature for 1 hour. Thereafter, filtration was performed, and the resultant residue was dried under reduced pressure, to obtain a red solid containing a metal complex M2a (2.57 g).

### (Stage 5: Synthesis of metal complex M2)

An argon gas atmosphere was made in a light-shielded reaction vessel, then, the red solid containing the metal complex M2a (1.2 g), the compound L2 (540 mg), silver(I) trifluoromethanesulfonate (260 mg), 2,6-lutidine (0.108 mL) and diethylene glycol dimethyl ether (14.4 mL) were added, and the mixture was stirred at 140°C for 22 hours.

The resultant reaction mixture was cooled down to room temperature, then, added into methanol (30 mL), and the mixture was stirred at room temperature for 1 hour. Thereafter, filtration was performed, toluene (20 mL) was added to the resultant residue, activated carbon was added and the mixture was stirred for 30 minutes, then, filtrated through a filter paved with Celite, and the resultant filtrate was concentrated under reduced pressure, to obtain a solid.

The resultant solid was purified sequentially by silica gel column chromatography (toluene/hexane) and crystallization (ethyl acetate, n-hexane), then, dried under reduced pressure, to obtain a metal complex M2 (420 mg, yield: 25% with respect to the charged amount of IrCl₃●3H₂O which is trihydrate of iridium(III) chloride) as a red solid. The metal complex M2 showed an HPLC area percentage value of 98.0% or more.

LC-MS (APCI, positive): m/z = 2253.1 [M+H]⁺

### <Acquisition of metal complex CM1 and metal complex CM2>

A metal complex CM1 and a metal complex CM2 manufactured by Luminescence Technology were used.

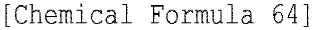

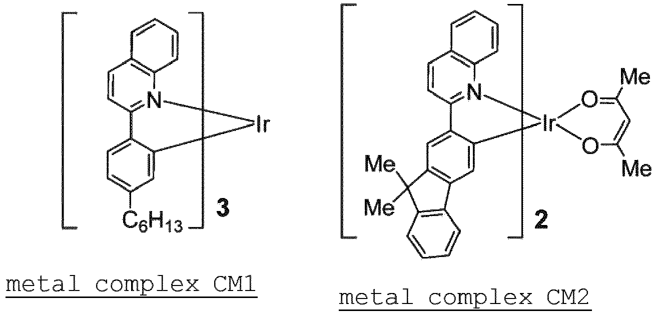

### <Comparative Example 1> Synthesis of metal complex CM3

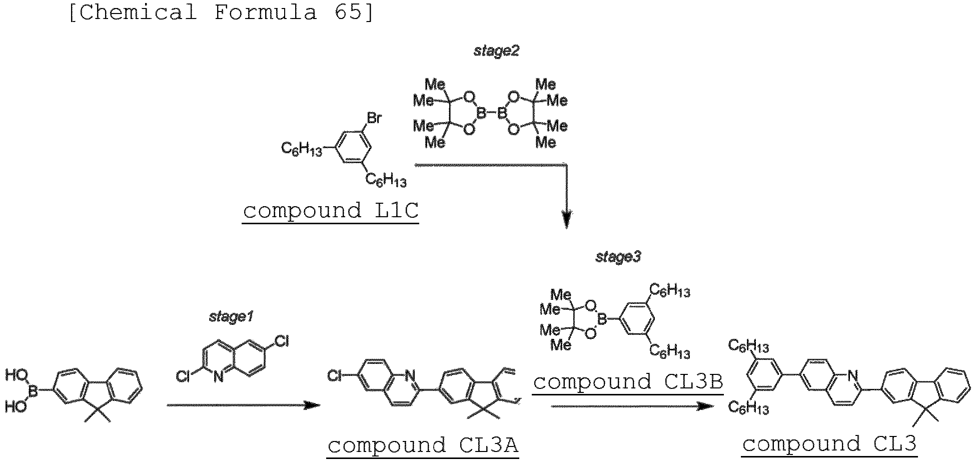

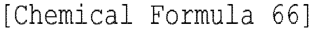

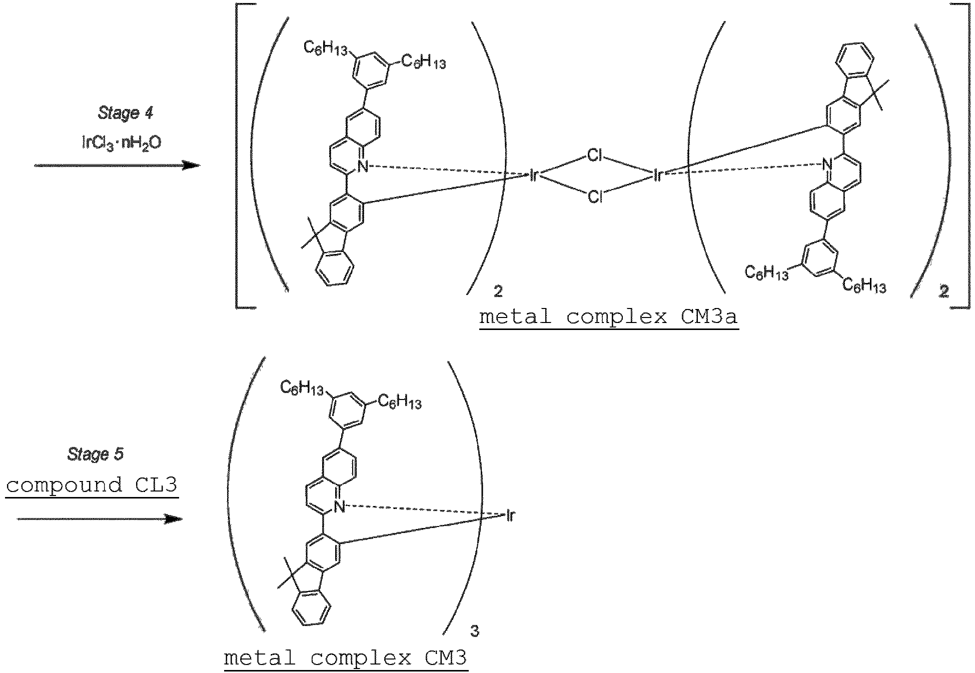

### (Stage 1: Synthesis of compound CL3A)

A nitrogen atmosphere was made in a reaction vessel, then, 9,9'-dimethylfluorene-2-boronic acid (5 g), 2,6-dichloroquinoline (4.6 g), tetrakis(triphenylphosphine)palladium(0) (1.2 g), a 20% by mass tetraethyl ammonium hydroxide aqueous solution (61.9 g) and toluene (250 mL) were added, and the mixture was stirred at 85°C for 2 hours. The resultant reaction liquid was cooled down to room temperature, then, ion exchanged water (50 mL) was added, and the mixture was filtrated through a filter paved with Celite, and an aqueous layer was removed. The resultant organic layer was washed with ion exchanged water, then, dried over anhydrous magnesium sulfate, filtrated through a filter paved with Celite and silica gel, and the resultant filtrate was concentrated under reduced pressure, to obtain a coarse product. The resultant coarse product was crystallized using a mixed solvent of toluene and ethanol, then, dried under reduced pressure, to obtain a compound CL3A (4.9 g). The compound CL3A showed an HPLC area percentage value of 99.9%.

¹H-NMR (400 MHz, CDCl₃) δ: 8.27 (s, 1H), 8.15-8.10 (m, 3H), 7.98 (d, 1H), 7.86 (d, 1H), 7.81-7.77 (m, 2H), 7.68 (d, 1H), 7.49-7.45 (m, 1H), 7.39-7.34 (m, 2H), 1.58 (s, 6H) .

### (Stage 2: Synthesis of compound CL3B)

A nitrogen atmosphere was made in a reaction vessel, then, the compound L1C (260.0 g), bis(pinacolato)diboron (223.2 g), potassium acetate (117.6 g), [1,1'-bis (diphenylphosphino)ferrocene]dichloropalladium(II)-dichloromethane adduct (13.5 g) and 1,2-dimethoxyethane (2.6 L) were added, and the mixture was stirred with heating at 80°C for 7.5 hours. Thereafter, toluene was added, and the mixture was filtrated through a filter paved with Celite, and the resultant filtrate was concentrated under reduced pressure. Thereafter, toluene and activated carbon were added, and the mixture was stirred at room temperature for 30 minutes, then, filtrated through a filter paved with Celite, the resultant filtrate was concentrated under reduced pressure, and further crystallized using an acetonitrile solvent, to obtain a compound CL3B (243.5 g) as a white solid. The compound CL3B showed an HPLC area percentage value of 99.5% or more.

### (Stage 3: Synthesis of compound CL3)

A nitrogen atmosphere was made in a reaction vessel, then, the compound CL3A (4.2 g), the compound CL3B (4.8 g), tris(dibenzylideneacetone)dipalladium(0) (0.17 g), 2-dicyclohexylphosphino-2',6'-dimethoxybiphenyl (0.24 g), toluene (84 mL) and a 20% by mass tetrabutyl ammonium hydroxide aqueous solution (46 g) were added, and the mixture was stirred with heating at 90°C for 4 hours. The resultant reaction liquid was cooled down to room temperature, then, ion exchanged water was added, and the mixture was filtrated through a filter paved with Celite, and an aqueous layer was removed. The resultant organic layer was washed with ion exchanged water, then, dried over anhydrous magnesium sulfate, filtrated through a filter paved with Celite and silica gel, and the resultant filtrate was concentrated under reduced pressure. It was purified by silica gel column chromatography (a mixed solvent of toluene and n-hexane), and concentrated under reduced pressure, to obtain a compound CL3 (7.5 g) as a colorless oil. The compound CL3 showed an HPLC area percentage value of 99.5% or more.

¹H-NMR (400 MHz, CDCl₃) δ: 8.26 (m, 3H), 8.16 (dd, 1H), 8.02-8.00 (m, 2H), 7.98 (d, 1H), 7.87 (d, 1H), 7.78 (d, 1H), 7.49-7.47 (m, 1H), 7.39-7.35 (m, 4H), 7.04 (s, 1H), 2.70 (t, 4H), 1.67 (quin, 4H), 1.60 (s, 6H), 1.41-1.28 (m, 12H), 0.91-0.87 (m, 6H).

### (Stage 4: Synthesis of metal complex CM3a)

An argon gas atmosphere was made in a light-shielded reaction vessel, then, iridium(III) chloridehydrate (0.5 g), the compound CL3 (2.00 g) and 2-ethoxyethanol (16 mL) were added, and the mixture was stirred at 130°C for 30 hours.

The resultant reaction mixture was cooled down to room temperature, then, added into methanol (27 mL), and the mixture was stirred at room temperature for 1 hour. Thereafter, filtration was performed, toluene (54 mL) was added to the resultant residue to dissolve it, and it was washed with ion exchanged water, then, dried over anhydrous magnesium sulfate, filtrated through a filter paved with Celite, and the resultant filtrate was concentrated under reduced pressure, to obtain a solid. Methanol (27 ml) was added to the resultant solid, and the mixture was stirred, and filtrated, to obtain a metal complex CM3a (1.46 g) as a red solid. The metal complex CM3a showed an HPLC area percentage value of 99.0% or more.

### (Stage 5: Synthesis of metal complex CM3)

An argon gas atmosphere was made in a light-shielded reaction vessel, then, the metal complex CM3a (1.30 g), the compound CL3 (569 mg), silver(I) trifluoromethanesulfonate (332 mg), 2,6-lutidine (0.139 mL) and diethylene glycol dimethyl ether (16.3 mL) were added, and the mixture was stirred at 150°C for 45 hours.

The resultant reaction mixture was cooled down to room temperature, then, added into methanol (39 mL), and the mixture was stirred at room temperature for 1 hour, then, filtration was performed, to obtain a solid.

The resultant solid was purified sequentially by silica gel column chromatography (toluene/hexane) and crystallization (toluene, ethanol), then, dried under reduced pressure, to obtain a metal complex CM3 (790 mg, yield: 31% with respect to the charged amount of IrCl₃●3H₂O which is trihydrate of iridium(III) chloride) as a red solid. The metal complex CM3 showed an HPLC area percentage value of 99.0% or more.

LC-MS (ESI, positive): m/z = 1887.1 [M+H]⁺

### <Synthesis Example 1> Synthesis of polymer compound IP1

A polymer compound IP1 was synthesized by a method described in JP-A No. 2012-144722 using a monomer PM1 synthesized according to a method described in JP-A No. 2011-174062, a monomer PM2 synthesized according to a method described in International Publication WO 2005/049546, a monomer PM3 synthesized according to a method described in International Publication WO 2002/045184, and a monomer PM4 synthesized according to a method described in JP-A No. 2008-106241.

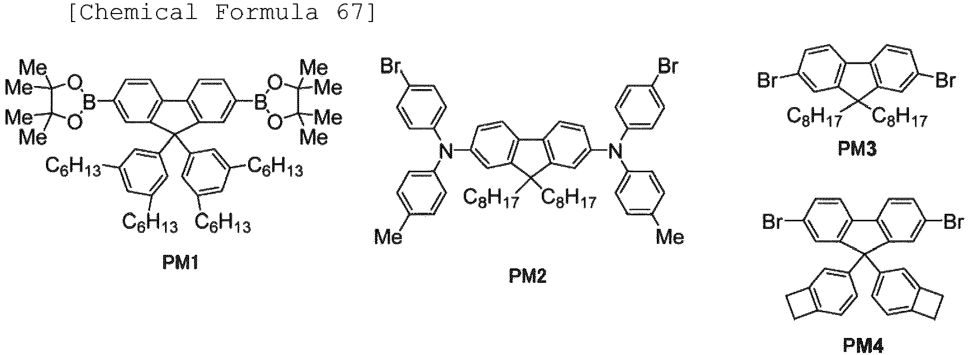

The polymer compound IP1 is a copolymer constituted of a constitutional unit derived from the monomer PM1, a constitutional unit derived from the monomer PM2, a constitutional unit derived from the monomer PM3 and a constitutional unit derived from the monomer PM4 at a molar ratio of 50:30:12.5:7.5, according to the theoretical value determined from the amounts of the charged raw materials.

### <Synthesis Example 2> Synthesis of polymer compound P1

A polymer compound P1 was synthesized by a method described in International Publication WO 2012/133381 using a monomer PM5 synthesized according to a method described in International Publication WO 2012/086671, a monomer PM3 synthesized according to a method described in International Publication WO 2002/045184, and a monomer PM6 synthesized according to a method described in JP-A No. 2004-143419.

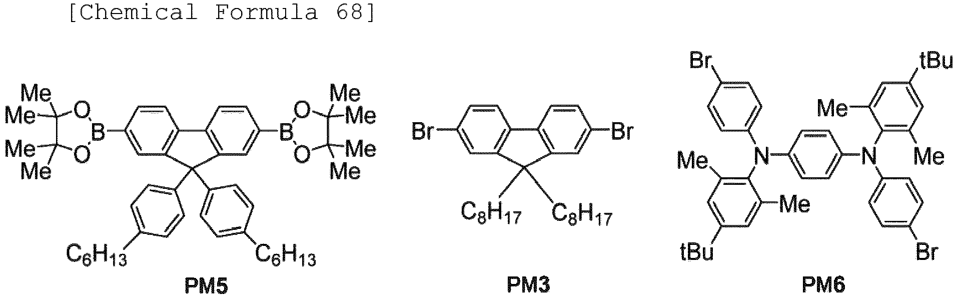

The polymer compound P1 is a copolymer constituted of a constitutional unit derived from the monomer PM5, a constitutional unit derived from the monomer PM3 and a constitutional unit derived from the monomer PM6 at a molar ratio of 50:45:5, according to the theoretical value determined from the amounts of the charged raw materials.

### <Example D1> Fabrication and evaluation of light emitting device D1

### (Formation of anode and hole injection layer)

An ITO film with a thickness of 45 nm was attached to a glass substrate by a sputtering method, to form an anode. On the anode, a hole injection material ND-3202 (manufactured by Nissan Chemical Corporation) was spin-coated to form a film with a thickness of 65 nm. The substrate carrying the hole injection layer laminated thereon was heated on a hot plate at 50°C for 3 minutes under an air atmosphere, and further heated at 240°C for 15 minutes, to form a hole injection layer.

### (Formation of hole transporting layer)

The polymer compound IP1 was dissolved in xylene at a concentration of 0.6% by mass. The resultant xylene solution was spin-coated to form a film with a thickness of 20 nm on the hole injection layer, and the film was heated on a hot plate at 180°C for 60 minutes under a nitrogen gas atmosphere, to form a hole transporting layer.

### (Formation of light emitting layer)

The polymer compound P1 and the metal complex M1 (polymer compound P1/metal complex M1 = 92% by mass/8% by mass) were dissolved in xylene at a concentration of 2% by mass. The resultant xylene solution was spin-coated to form a film with a thickness of 90 nm on the hole transporting layer, and the film was heated at 150°C for 10 minutes under a nitrogen gas atmosphere, to form a light emitting layer.

### (Formation of cathode)

The substrate carrying the light emitting layer formed thereon was placed in a vapor deposition machine, and the internal pressure thereof was reduced to 1.0 × 10⁻⁴ Pa or less, then, sodium fluoride was vapor-deposited with a thickness of about 4 nm on the light emitting layer, then, aluminum was vapor-deposited with a thickness of about 80 nm on the sodium fluoride layer as cathodes. After vapor deposition, sealing was performed using a glass substrate, to fabricate a light emitting device D1.

### (Evaluation of light emitting device)

Voltage was applied to the light emitting device D1 to observe light emission having the maximum peak of light emission spectrum at 605 nm. The CIE chromaticity coordinate (x, y) = (0.63, 0.36), and the external quantum efficiency at 1000 cd/m² was 15.1%.

<Example D2> Fabrication and evaluation of light emitting device D2

A light emitting device D2 was fabricated in the same manner as in Example D1, except that the metal complex M2 was used instead of the metal complex M1.

Voltage was applied to the light emitting device D2 to observe light emission having the maximum peak of light emission spectrum at 605 nm. The CIE chromaticity coordinate (x, y) = (0.61, 0.39), and the external quantum efficiency at 1000 cd/m² was 14.3%.

### <Comparative Example CD1> Fabrication and evaluation of light emitting device CD1

A light emitting device CD1 was fabricated in the same manner as in Example D1, except that the metal complex CM1 was used instead of the metal complex M1.

Voltage was applied to the light emitting device CD1 to observe light emission having the maximum peak of light emission spectrum at 590 nm. The CIE chromaticity coordinate (x, y) = (0.57, 0.42), and the external quantum efficiency at 1000 cd/m² was 5.4%.

### <Comparative Example CD2> Fabrication and evaluation of light emitting device CD2

A light emitting device CD2 was fabricated in the same manner as in Example D1, except that the metal complex CM2 was used instead of the metal complex M1.

Voltage was applied to the light emitting device CD2 to observe light emission having the maximum peak of light emission spectrum at 620 nm. The CIE chromaticity coordinate (x, y) = (0.67, 0.33), and the external quantum efficiency at 1000 cd/m² was 3.8%.

### <Comparative Example CD3> Fabrication and evaluation of light emitting device CD3

A light emitting device CD3 was fabricated in the same manner as in Example D1, except that the metal complex CM3 was used instead of the metal complex M1.

Voltage was applied to the light emitting device CD3 to observe light emission having the maximum peak of light emission spectrum at 610 nm. The CIE chromaticity coordinate (x, y) = (0.65, 0.35), and the external quantum efficiency at 1000 cd/m² was 8.5%.

### Industrial Applicability

The metal complex according to the present invention is useful for production of a light emitting device excellent in light emission efficiency. Further, the light emitting device according to the present invention can be suitably used for display, illumination, and the like, because of its excellent light emission efficiency.

## Claims

1. A metal complex represented by the formula (1): 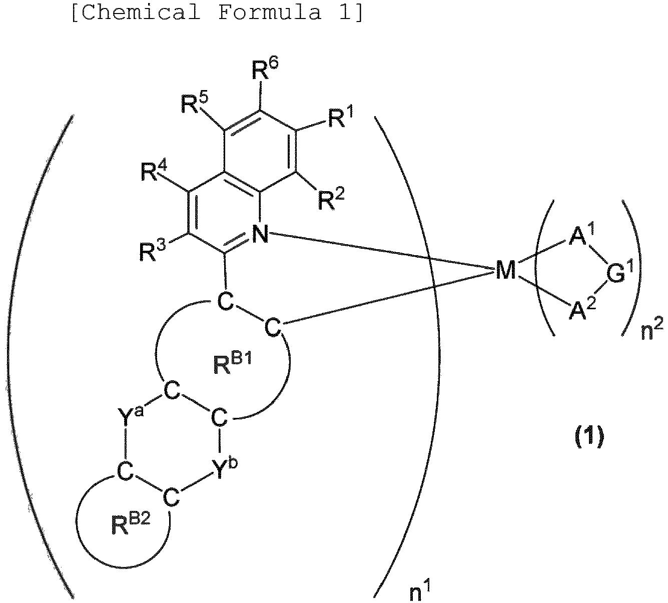 wherein,
M represents a rhodium atom, a palladium atom, an iridium atom or a platinum atom,
n¹ represents 1, 2 or 3, n² represents 0, 1 or 2, n¹+n² is 3 when M is a rhodium atom or an iridium atom, while n¹+n² is 2 when M is a platinum atom or a palladium atom,
R¹, R², R³, R⁴, R⁵ and R⁶ each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and these groups optionally have a substituent, when a plurality of the substituents are present, they may be combined together to form a ring together with atoms to which they are attached, when a plurality of R¹, R², R³, R⁴, R⁵ and R⁶ are present, they may be the same or different at each occurrence, R³ and R⁴, R⁴ and R⁵, R⁵ and R⁶, and R¹ and R² may each be combined together to form a ring together with carbon atoms to which they are attached,
Ring R^{B1} and Ring R^{B2} each independently represent an aromatic hydrocarbon ring or an aromatic hetero ring, and these rings optionally have a substituent, when a plurality of the substituents are present, they may be combined together to form a ring together with atoms to which they are attached, the substituent which Ring R^{B1} optionally has and R³ may be combined together to form a ring together with atoms to which they are attached, when a plurality of Ring R^{B1} and Ring R^{B2} are present, they may be the same or different at each occurrence,
one of Y^{a} and Y^{b} is a single bond, and the other is a group represented by the formula (C-1): 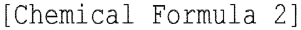 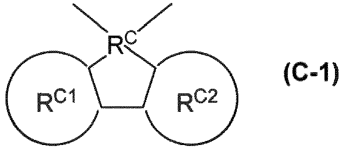 wherein,
R^{C} represents a carbon atom, a silicon atom, a germanium atom, a tin atom or a lead atom,
Ring R^{C1} and Ring R^{C2} each independently represent an aromatic hydrocarbon ring or an aromatic hetero ring, and these rings optionally have a substituent, when a plurality of the substituents are present, they may be combined together to form a ring together with atoms to which they are attached, the substituent which Ring R^{C1} optionally has and the substituent which Ring R^{C2} optionally has may be combined together to form a ring together with atoms to which they are attached; when a plurality of Y^{a} and Y^{b} are present, they may be the same or different at each occurrence,
A¹-G¹-A² represents an anionic bidentate ligand, and G¹ represents an atomic group constituting a bidentate ligand together with A¹ and A², A¹ and A² each independently represent a carbon atom, an oxygen atom or a nitrogen atom, and these atoms may be ring-constituent atoms, when a plurality of A¹-G¹-A² are present, they may be the same or different.

2. The metal complex according to claim 1, wherein the metal complex represented by the formula (1) is a metal complex represented by the formula (1-A1), the formula (1-A2) or the formula (1-A3): 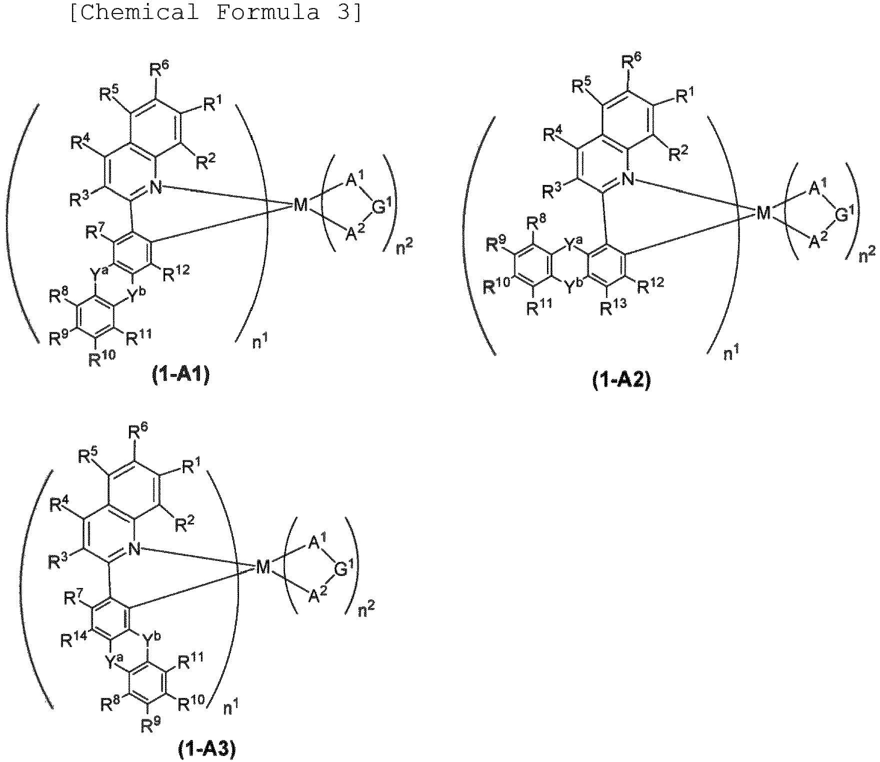 wherein,
M, n¹ , n² , R¹ , R², R³ , R⁴ , R⁵ , R⁶ , Y^{a} , Y^{b} and A¹ -G¹ -A² represent the same meaning as described above,
R⁷, R⁸ , R⁹, R¹⁰ , R¹¹ , R¹² , R¹³ and R¹⁴ each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and these groups optionally have a substituent, when a plurality of the substituents are present, they may be combined together to form a ring together with atoms to which they are attached, when a plurality of R⁷, R⁸, R⁹, R¹⁰ , R¹¹ , R¹², R¹³ and R¹⁴ are present, they may be the same or different at each occurrence, R⁸ and R⁹, R⁹ and R¹⁰ , R¹⁰ and R¹¹ , R¹² and R¹³, R⁷ and R¹⁴ , and R⁷ and R³ may each be combined together to form a ring together with atoms to which they are attached.

3. The metal complex according to claim 1 or 2,
wherein the group represented by the formula (C-1) is a group represented by the formula (C-2): 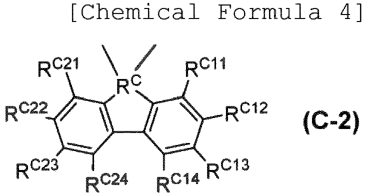 wherein,
R^{C} represents the same meaning as described above,
R^{C11}, R^{C12}, R^{C13} , R^{C14} , R^{C21} , R^{C22} , R^{C23} and R^{C24} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and these groups optionally have a substituent, when a plurality of the substituents are present, they may be combined together to form a ring together with atoms to which they are attached, when a plurality of R^{C11}, R^{C12}, R^{C13}, R^{C14}, R^{C21}, R^{C22}, R^{C23} and R^{C24} are present, they may be the same or different at each occurrence, R^{C11} and R^{C12}, R^{C12} and R^{C13}, R^{C13} and R^{C14}, R^{C14} and R^{C24}, R^{C24} and R^{C23}, R^{C23} and R^{C22}, and R^{C22} and R^{C21} may each be combined together to form a ring together with atoms to which they are attached.

4. The metal complex according to claim 3, wherein the metal complex represented by the formula (1) is a metal complex represented by the formula (1-A1-1): 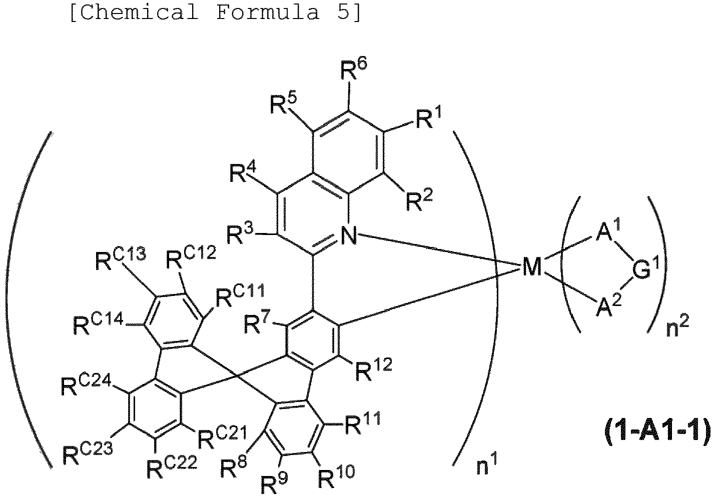 wherein,
M, n¹ , n², R¹ , R², R³ , R⁴ , R⁵ , R⁶ , R^{C11} , R^{C12}, RC¹³ , R^{C14}, R^{C21}, R^{C22}, R^{C23}, R^{C24} and A¹-G¹-A² represent the same meaning as described above,
R⁷, R⁸, R⁹, R¹⁰ , R¹¹ and R¹² each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and these groups optionally have a substituent, when a plurality of the substituents are present, they may be combined together to form a ring together with atoms to which they are attached, when a plurality of R⁷, R⁸, R⁹, R¹⁰ , R¹¹ and R¹² are present, they may be the same or different at each occurrence, R⁸ and R⁹, R⁹ and R¹⁰ , R¹⁰ and R¹¹, and R⁷ and R³ may each be combined together to form a ring together with atoms to which they are attached.

5. The metal complex according to any one of claims 1 to 4, wherein the n² is 0.

6. A composition comprising the metal complex as described in any one of claims 1 to 5, and at least one selected from the group consisting of a hole transporting material, a hole injection material, an electron transporting material, an electron injection material, a light emitting material, an antioxidant and a solvent.

7. A composition comprising the metal complex as described in any one of claims 1 to 5, and at least one selected from the group consisting of a compound represented by the formula (H-1) and a polymer compound having a constitutional unit represented by the formula (Y) : 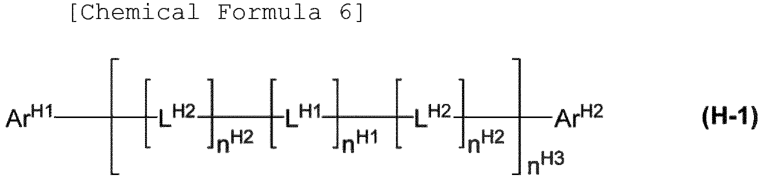 wherein,
Ar^{H1} and Ar^{H2} each independently represent an aryl group or a monovalent hetero ring group, and these groups optionally have a substituent,
n^{H1} and n^{H2} each independently represent 0 or 1, when a plurality of n^{H1} are present, they may be the same or different, a plurality of n^{H2} may be the same or different,
n^{H3} represents an integer of 0 or more,
L^{H1} represents an arylene group, a divalent hetero ring group or a group represented by -[C(R^{H11})₂]n^{H11}-, and these groups optionally have a substituent, when a plurality of L^{H1} are present, they may be the same or different, n^{H11} represents an integer of 1 or more and 10 or less, R^{H11} represents a hydrogen atom, an alkyl group, a cycloalkyl group, an alkoxy group, a cycloalkoxy group, an aryl group or a monovalent hetero ring group, and these groups optionally have a substituent, a plurality of R^{H11} may be the same or different and may be combined together to form a ring together with carbon atoms to which they are attached,
L^{H2} represents a group represented by -N(R^{H21})-, when a plurality of L^{H2} are present, they may be the same or different, R^{H21} represents a hydrogen atom, an alkyl group, a cycloalkyl group, an aryl group or a monovalent hetero ring group, and these groups optionally have a substituent, 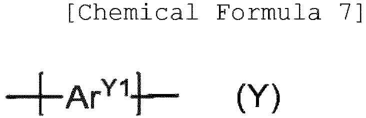 wherein, Ar^{Y1} represents an arylene group, a divalent hetero ring group or a divalent group in which an arylene group and a divalent hetero ring group are bonded directly, and these groups optionally have a substituent.

8. A light emitting device comprising the metal complex as described in any one of claims 1 to 5.
